(19) Europäisches Patentamt / European Patent Office / Office européen des brevets

(11) **EP 1 614 704 B1**

(12) # EUROPEAN PATENT SPECIFICATION

(45) Date of publication and mention of the grant of the patent:
**19.01.2011 Bulletin 2011/03**

(21) Application number: **04723799.5**

(22) Date of filing: **26.03.2004**

(51) Int Cl.:
***C08G 73/10*** *(2006.01)* ***G03F 7/039*** *(2006.01)*
***G03F 7/037*** *(2006.01)*

(86) International application number:
**PCT/JP2004/004305**

(87) International publication number:
**WO 2004/087793 (14.10.2004 Gazette 2004/42)**

(54) **CROSSLINKED POLYIMIDE, COMPOSITION COMPRISING THE SAME AND METHOD FOR PRODUCING THE SAME**

VERNETZTES POLYAMID, DIESES ENTHALTENDE ZUSAMMENSETZUNG UND HERSTELLUNGSVERFAHREN DAFÜR

POLYIMIDE RETICULE, COMPOSITION COMPRENANT CE POLYIMIDE ET PROCEDE PERMETTANT SA PRODUCTION

(84) Designated Contracting States:
**AT BE BG CH CY CZ DE DK EE ES FI FR GB GR HU IE IT LI LU MC NL PL PT RO SE SI SK TR**

(30) Priority: **28.03.2003 JP 2003090546**
**17.04.2003 JP 2003112425**
**11.12.2003 JP 2003412832**

(43) Date of publication of application:
**11.01.2006 Bulletin 2006/02**

(73) Proprietor: **PI R & D Co. Ltd**
**Yokohama-shi,**
**Kanagawa 236-0002 (JP)**

(72) Inventor: **ITATANI, Hiroshi,**
**c/o PI R & D CO., LTD.**
**Yokohama-shi,**
**Kanagawa, 2360002 (JP)**

(74) Representative: **Stuart, Ian Alexander**
**Mewburn Ellis LLP**
**33 Gutter Lane**
**London**
**EC2V 8AS (GB)**

(56) References cited:
**JP-A- 3 109 424** **JP-A- 9 227 697**
**JP-A- 2002 060 488**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 614 704 B1

## Description

Technical Field

The present invention relates to a process of producing a cross-linked polyimide composition. The cross-linked polyimide produced according to the present invention is excellent in heat resistance, insulation properties and in mechanical characteristics as in the conventional linear and crystalline polyimides. Furthermore it is non-crystalline, has better adhesiveness, dimensional stability, chemical resistance (anti-cracking) and thermal decomposition property than the conventional polyimides. The cross-linked polyimide composition produced by the present invention may be used to form films, multilayer substrates, multilayer laminates and molded articles, so that it is a useful material for aerospace industry, electrical and electronic parts and for car parts. Particularly, the cross-linked polyimide as produced in the present invention has a low dielectric constant, so that it is especially useful for electric or electronic equipments or for parts thereof.

Background Art

Due to the progress in precise processing technology, integrated circuits have been highly integrated, multifunctionalized, and highly densified, and their performances are now being drastically promoted. As a result, the circuit resistances and the capacitances of capacitors between interconnections are increased. These results in not only increase in power consumption but also increase in the lag time, which is a major cause of the decrease in signal speeds in devices. One of the solutions is to coat the vicinities of interconnections with interlayer insulation films having low dielectric constants, thereby decreasing the parasitic capacitances to speed up the device operations. The widths of interlayer insulation films became 0.25 $\mu$m in 2001, and then 0.18 $\mu$m. For this, a film with a low dielectric constant is demanded. Although polyimides are excellent in heat resistance, electric insulation properties and in mechanical strengths, the dielectric constants of the conventional polyimides are 3.5 to 3.0. To decrease the dielectric constant, introduction of fluorine atoms, introduction of fine air holes and introduction of a fullerene-based material have been tried, but these methods deteriorate the quality of polyimides. Thus, decrease in the diclectric constants of polyimide films *per se* is demanded.

On the other hand, dendrimers, dendrons and hyperbranched polymers, of which molecular structures are largely different from those of the linear polymers, have been synthesized, and are drawing attention from the view points of both functions and structures ("Science and Functions of Dendrimers", (Masahiko OKADA eds.), IPC (Tokyo), 2000).

Dendrimers arc high polymers having regular dendriform branched structures, and whose chemical structures, molecular weights, molecular shapes and molecular sizes are strictly controlled. Although the reports of polyimide dendrimers are few, $AB_2$ type and $A_2B$ type hyperbranched polyimides have been reported (Macromolecules (2000) 33, 1114; Macromolecules (2000) 33, 6937; Macromolecules (2001) 34,3910; Macromolecules (2002) 35, 5372)). Both of these polyimides are synthesized by two-step reactions in which a polyamic acid which is a precursor of polyimide is synthesized, and then the polyamic acid is imidized by heat treatment (300°C) and chemical treatment (immersion in acetic anhydride and pyridine). Hyperbranched polyimides were synthesized by generating a polyamic acid which is a precursor of polyimide by using a triamine (tris-4-aminophenyl)amine and an acid dianhydride, and then subjecting the polyamic acid to heat treatment or chemical treatment (Macromolecules (2000) 33, 4639). The properties of hyperbranched polymers are similar to those of dendrimers, that is, the viscosities are low, solubilities are high, non-crystalline and multifunctional (Macromolecules (2000) 33, 4639; Macromolecules (2002) 35, 3732).

Disclosure of the Invention

An object of the present invention is to make it possible to provide a novel polyimide which retains the properties of polyimides, that is, the excellent heat resistance, electric insulation properties and chemical resistance, and of which the dielectric constant is lower than those of the known polyimides, as well as a composition containing the same and a production process thereof Another object of the present invention is to make it possible to provide a composition containing a novel cross-linked polyimide which is excellent in heat resistance, insulation properties and mechanical characteristics as the conventional linear and crystalline polyimides, and has better adhesiveness, dimensional stability, chemical resistance (anti-cracking) and/or thermal decomposition property, which may be utilized as films, multilayer substrates, multilayer laminates, molded articles, for example. Still another object of the present invention is to make it possible to provide an electric or electronic equipment or a part thereof, which comprises a novel polyimide that retains the properties of the polyimides, that is, excellent heat resistance, electric insulation properties and chemical resistance, and has a lower dielectric constant than those of the known polyimides, as an insulation material or insulating substrate or protection material.

The present inventor intensively studied to discover that a cross-linked structure and cyclic structures are given

to the polyimide by making a tetramine coexist in the reaction between a tetracarboxylic dianhydride and an aromatic diamine in the production process of a polyimide, in which the polyimide is directly formed from the tetracarboxylic dianhydride and the aromatic diamine using a catalyst in a solvent containing toluene or xylene, so that a polyimide which retains the properties of the polyimides, that is, excellent heat resistance, electric insulation properties and chemical resistance, and has a lower dielectric constant than those of the known polyimides may be obtained, thereby completing the present invention.

That is, the present invention provides a process for producing a composition containing a cross-linked polyimide produced by polycondensing one or more tetramine(s), one or more tetracarboxylic dianhydride(s) and one or more aromatic diamine(s) in a polar solvent containing toluene or xylene, in the presence of a catalyst, with heating, whereby polymide is formed directly. The thus-produced cross-linked polyimide may have a dielectric constant of not more than 2.7.

By the present invention, a novel polyimide which retains the properties of polyimides, that is, the excellent heat resistance, electric insulation properties and chemical resistance, and of which dielectric constant is lower than those of the known polyimide was first provided. Especially, diaminosiloxane-containing polyimides have extremely low dielectric constants of 1.9 to 2.2, so that they are especially demanded in highly densified, highly integrated circuits, and are useful as interlayer insulation films, laminates, multilayer flexible substrates. Although the polyimides provided by the present invention are usually in gel state at room temperature, they can be provided in the form of a uniform solution by being mixed with a linear polyimide solution or by generating the cross-linked polyimide in a linear polyimide solution.

The cross-linked polyimide in the composition produced by the process according to the present invention is non-crystalline, and is excellent in adhesiveness, dimensional stability and in resistance to thermal decomposition, and also excellent in weatherability and chemical resistance (anti-cracking). They may be used, for example, as films, laminates, multilayer flexible substrates, surface-protection films, solar batteries, and for protection (anti-cracking) of insides of oil pipelines.

If polyimides produced by means of the invention and having lower dielectric constants than conventional polyimides are used as insulation materials, insulating substrates or protection materials in electric or electronic equipments or parts thereof, the power consumption of the devices may be decreased, the signal speeds may be increased and transmission losses of signals may be decreased.

Brief Description of the Drawings

Fig. 1 shows the relationship between the wavelength at which the dielectric constant of the polyimide film produced in Example 1 was measured and the dielectric constant or the measured value of tangent δ.

Fig. 2 shows the relationship between the wavelength at which the dielectric constant of the polyimide film produced in Example 8 was measured and the dielectric constant or the measured value of tangent 8.

Fig. 3 shows the relationship between the wavelength at which the dielectric constant of $SiO_2$ was measured and the dielectric constant or the measured value of tangent δ.

Fig. 4 shows the relationship between the wavelength at which the dielectric constant of air was measured and the dielectric constant or the measured value of tangent δ.

Fig. 5 shows NMR of bis-(3,4-diaminobenzoyl)-piperazine.

Fig. 6 shows IR spectrum of Example 17.

Fig. 7 shows the molecular weight distribution curve of Example 14.

Fig. 8 shows the molecular weight distribution curve of Example 15.

Fig. 9 shows the TG-GTA curve of Example 14.

Fig. 10 shows the TG-GTA curve of Example 14.

Best Mode for Carrying Out the Invention

As mentioned above, according to the present invention, a composition is produced by polycondensing (a) tetramine(s), (a) tetracarboxylic dianhydride(s) and (an) aromatic diamine(s). By using the tetramine(s) as a part of the diamine component, cross-linked structure is generated and large cyclic structures are generated thereby (this will be described later in detail). By virtue of the cross-linked and large cyclic structures, polyimides having low dielectric constants, which hitherto could not be attained, are obtained.

The dielectric constant of the polyimide obtained according to the present invention is desirably not more than 2.7, preferably not more than 2.2. The lower limit of the dielectric constant is not limited, but a polyimide having a dielectric constant of about 1.9 has been obtained. Thus, the range of the dielectric constant in the present invention is usually about 1.9 to 2.7, preferably about 1.9 to 22. The dielectric constant may be measured by a conventional method which will be described concretely in Examples below. That is, the dielectric constant may be measured by using a commercially

available LCR meter by the conventional method described in the instructions thereof. In Examples below, dielectric constants at frequencies of 1000 kHz and 3000 kHz are measured. Although the measurement results are almost identical, if at least one of the dielectric constants measured at 1000 kHz and 3000 kHz is not more than 2.7, it is construed that the requirement about the dielectric constant of the present invention is met.

Although the tetramine used in the production of the polyimide according to the present invention is not restricted at all as long as it is a tetramine because it can form the cross-linked structure and the large cyclic structures (described below), aromatic tetramines, particularly tetramines containing 2 to 4 benzene rings are preferred, and tetramines containing 4 benzene rings are especially preferred.
Further, tetramines in which the 4 amino groups are attached to the basal skeleton such that they are symmetrical about horizontal and vertical lines (when depicted into chemical formula, they are symmetrical about horizontal and vertical lines when viewed from at least one direction) (hereinafter also referred to as "H-shaped tetramine") are preferred, and bis (3,5-diaminobenzoyl)-1,4-piperazine (hereinafter also referred to as "BDP") shown in the structural formula (1) below is most preferred. BDP may be produced by a known method in which 3,5-diaminobenzoic acid and piperazine are reacted in N-methylpyrrolidone (NMP) as described concretely in Synthesis Examples below. Examples of preferred tetramines other than BDP include bis(3,5-diaminobertzoyl)-4,4'-diaminodiphcnyl ether represented by the structural formula (2) below, bis(3,5-diaminodiphenyl)-2,2'-dioxazol-4,4'-diphenyl sulfone represented by the structural formula (3) below, bis(3,5-diaminophenyl)-2,2'-dioxazol-4,4'-biphenyl represented by the structural formula (4), bis(9,9'-4-aminophenyl)-2,7-diaminofluorene represented by the structural formula (5) and bis(3,5-diaminobenzoyl)-1,4-diaminobenzene. Production processes of these tetramines are also known, and are described concretely in Synthesis Examples below.

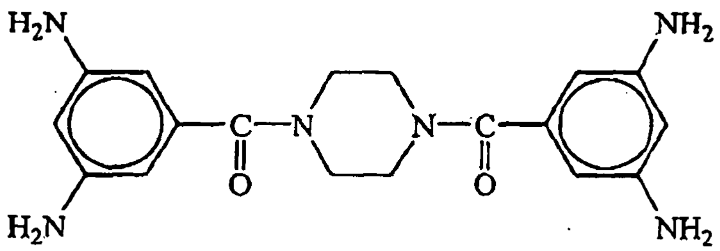
(1)

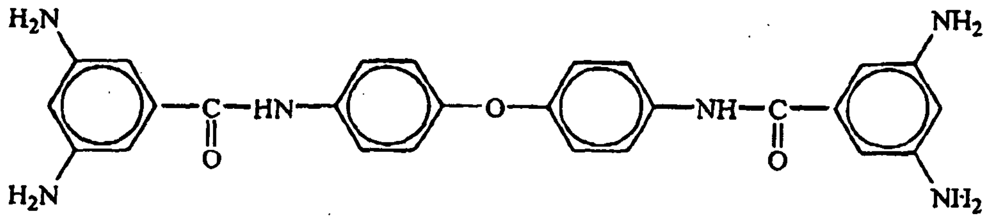
(2)

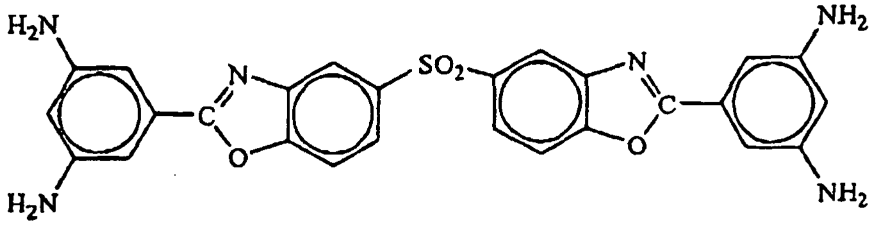
(3)

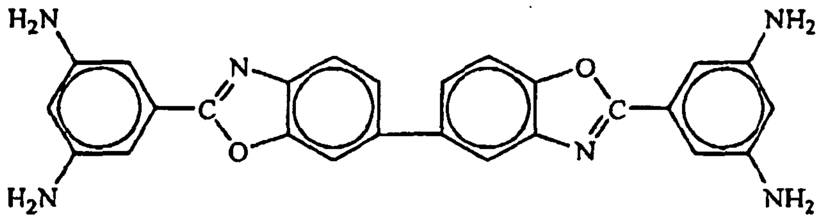

(4)

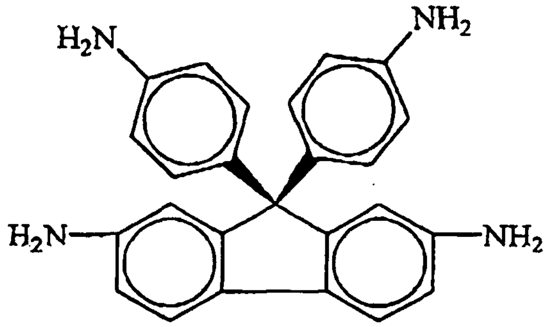

(5)

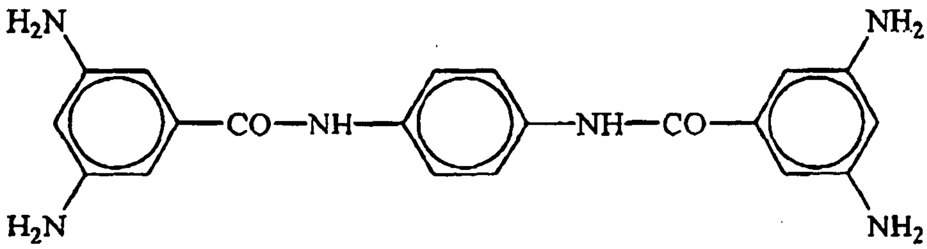

(6)

The tetramine may be used individually or two or more tetramines may be used in combination.

The tetracarboxylic dianhydride used in the production of the polyimide according to the present invention is not restricted, and any tetracarboxylic dianhydride used in the production of a known polyimide may be employed. Preferred examples include aromatic acid dianhydrides such as biphenyltetracarboxylic dianhydride, pyromellitic dianhydride, benzophenone tetracarboxylic dianhydride, bis(dicarboxyphenyl)propane dianhydride, 4,4'-[2,2,2-trifluoro-1-(trifluoromethyl)ethylidenc]bis(1,2-benzenedicarboxylic dianhydride, bis(carboxyphenyl)sulfone dianhydride, bis(dicarboxyphenyl)ether dianhydride, thiophene tetracarboxylic dianhydride and naphthalenetetracarboxylic dianhydride. The tetracarboxylic dianhydride may be used individually or two or more tetracarboxylic dianhydrides may be used in combination.

The aromatic diamine used in the production of the polyimide according to the present invention is not restricted, and any aromatic diamine used in the production of a known polyimide may be employed. Preferred examples include 1,4-benzenediamine, 1,3-benzenediamine, 2,4-diamino-3,3'-dimethyl-1,1'-biphenyl, 4,4'-amino-3,3'-dimethoxy-1,1'-biphenyl, 4,4'-mcthylenebis(benzeneamine), 4,4'-diaminodiphenyl ether, 3,4'-diaminodiphenyl ether (hereinafter referred to as "m-DADE"), 4,4'-diaminodiphenyl sulfide, 4,4'-diaminodiphenyl sulfone, 3,3'-diaminodiphenyl sulfone, 1-trifluoromethyl-2,2,2-trifluoroethylidine-4,4'-bis(benzeneamine), 3,5-diaminobenzoic acid, 2,6-diaminopyridine, 4,4'-diamino-3,3',5,5'-tetramethylbiphenyl, 2,2-bis(4(4-aminophenoxy)phenylpropane, bis(4-(4-aminophenoxy)phenyl)sulfone, bis(4 (3-aminophenoxy)phenyl)sulfone, 1,4-bis(4-aminophenoxy)benzene, 1,3-bis(4-aminophenoxy)benzene (hereinafter referred to as "m-TPE") and 9,9-bis(4-aminophenyl)fluorene (hereinafter referred to as "FDA"). The aromatic diamine may be used individually or two or more aromatic diamines may be used in combination.

Further, a diaminosiloxane may also be used. "Diaminosiloxane" means a diamine of which main chain constituting the polyimide is composed of siloxane structure. The number of silicon atoms in the siloxane structure is preferably about 1 to 50. Each silicon atom in the siloxane structure may be substituted with 1 or 2 lower ($C_1$-$C_6$) alkyl and/or lower ($C_1$-$C_6$) alkoxy group. Preferred examples are those represented by the general formula (7) below.

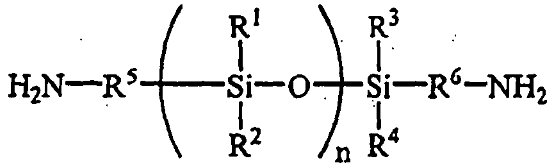

(7)

(wherein $R^1$, $R^2$, $R^3$ and $R^4$ independently represent $C_1$-$C_6$ alkyl or $C_1$-$C_6$ alkoxy; $R^5$ and $R^6$ independently represent single bond (i.e., $NH_2$ and Si are bound), $C_1$-$C_6$ alkylene or -$R^7$-O (wherein $R^7$ represents $C_1$-$C_6$ alkylene), n represents an integer of 0 to 49).

Among the diaminosiloxanes represented by the general formula (7), especially preferred are those represented by the following structural formula (8):

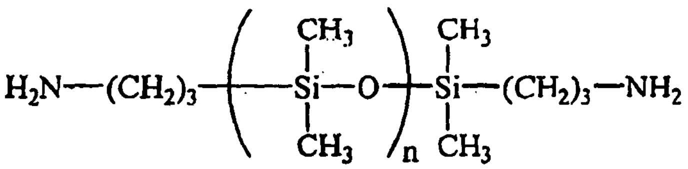

(8)

(wherein n represents an integer of 0 to 49).
Those having an amine number (the value obtained by dividing the molecular weight of the compound by the number of amino groups) of about 200 to 1000 are preferred.

The diaminosiloxane may be used individually or two or more diaminosiloxanes may be used in combination.

As will be described concretely in Examples below, by using the diaminosiloxane as one of the diamine component, polyimides having an especially low dielectric constant, i.e., polyimides having a dielectric constant as low as about 1.9 to 2.2 may be obtained. In cases where the polyimide contains (a) diaminosiloxane(s), although the content of the diaminosiloxane(s) in the total diamine component is not restricted, it is preferably 9 to 40 mol%, more preferably 18 to 30 mol%. In cases where the polyimide according to the present invention does not contain a diaminosiloxane, the dielectric constant thereof is about 2.4 to 2.7. Therefore, the present invention also provides a method for decreasing the dielectric constant of a cross-linked polyimide to 1.9 to 2.2 by using (a) diaminosiloxane(s) as a part of the diamine component when polycondensing (a) tetramine(s), (a) tetracarboxylic dianhydride(s) and (an) aromatic diamine(s) in a polar solvent containing toluene or xylene in the presence of a catalyst under heat.

As the catalyst used in the production of the polyimide according to the present invention, acid-base binary catalysts may preferably be employed. The imidation reaction is catalyzed by an acid, and the acid is easily solubilized in the solvent due to the existence of a base. As the acid, those which are easily thermally decomposed or vaporized by being heated to about 200"C and scattered are preferred. Preferred examples thereof include oxalic acid, malonic acid, formic acid, pyruvic acid and crotonic acid. For example, when oxalic acid or malonic acid is heated, they are thermally decomposed as shown below and scattered. The acids which are easily thermally decomposed or vaporized by being heated to about 200°C and scattered are preferred because they may be scattered and removed from the molded articles by the heat during molding. The acid may be used individually or two or more acids may be used in combination.

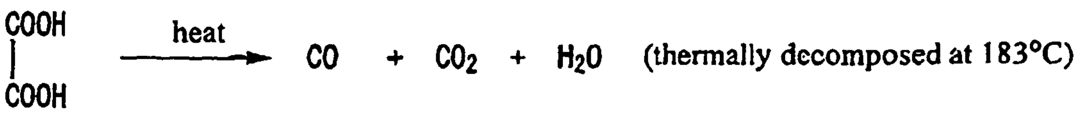


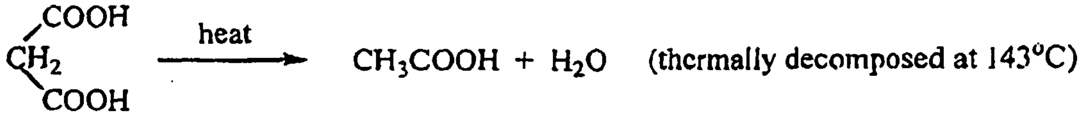

As the base of the acid-base binary catalyst, although any base may be employed as long as it can solubilizc the acid catalyst in the solvent, heterocyclic amines such as pyridine and methylmorpholine arc preferred. The base may be used individually or two or more bases may be used in combination.

Lactone-base binary catalysts which generate acids by chemical reactions may also preferably be employed. The reaction may be carried out by using a catalytic system utilizing the following equilibrium reaction between a lactone, base and water.

$$\{\text{lactone}\} + \{\text{base}\} + \{\text{water}\} = \{\text{acid}\}^{+}\{\text{base}\}^{-}$$

A polyimide solution may be obtained by using the $\{acid\}^{+}$ $\{base\}^{-}$ system as a catalyst and heating the reaction mixture at 140-180°C. The water produced by the imidation reaction is eliminated from the reaction system by azeotropic distillation with toluene or xylene. When the imidation in the reaction system is completed, $\{acid\}^{+}\{base\}^{-}$ is converted to the lactone and the base, and they lose the catalytic activity and are removed from the reaction system with toluene. The polyimidc solution produced by this process can be applied to a base film as it is as a polyimide solution with high purity because the above-mentioned catalytic substances are not contained in the polyimide solution after the reaction. As the lactone, γ-valerolactone is preferred. As the base, heterocyclic amines such as pyridine and methylmorpholine are preferred. As an example, the reaction between γ-valerolactone and pyridine is shown below.

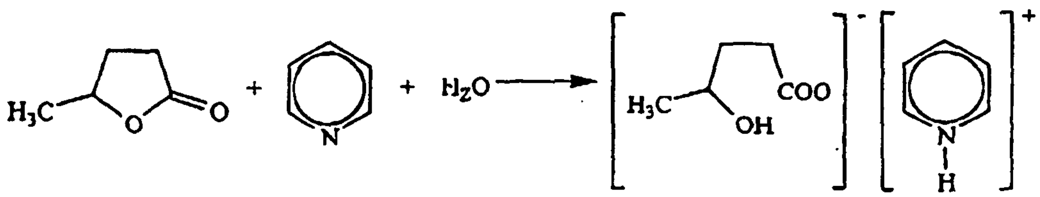

Although the amount of the acid or lactone of the above-described binary catalyst is not restricted, the concentration of the acid or lactone at the beginning of the reaction is 5 to 30 mol%, preferably about 5 to 20 mol% with respect to the concentration of the tetracarboxylic dianhydride, and the concentration of the base is preferably about 100 to 200 mol% with respect to the acid or lactone.

The solvent used for the reaction is a polar solvent containing toluene or xylene. By containing toluene or xylene, the water generated by the imidation may be removed to the outside of the reaction system by azeotropic distillation with toluene or xylene. Mixtures of toluene and xylene may also be used. Although the polar solvent is not restricted, preferred examples include N-methyl-2-pyrrolidone, dimethylformamide, dimethylacetamide, dimethylsulfoxide, sulfolane and tetramethylurea. The solvent may be used individually or two or more solvents may be used in combination.

The mixing ratio (acid/amine) of the tetracarboxylic dianhydride(s) to the amine component (diamine(s) and tetramine(s)) is preferably about 1.05 to 0.95 by mole. In the total reaction mixture at the time of the beginning of the reaction, the concentration of the tetracarboxylic dianhydride(s) is preferably about 4 to 16% by weight, the concentration of the acid or the lactone is preferably about 0.2 to 0.6% by weight, the concentration of the base is preferably about 0.3 to 0.9% by weight, and the concentration of toluene or xylene is preferably about 6 to 15% by weight. Although the reaction time is not restricted, and varies depending on the molecular weight of the polyimide to be produced and so on, the reaction time is usually about 3 to 15 hours. The reaction is preferably carried out under stirring. The reaction temperature is not restricted and is preferably 160°C to 200°C. In cases where an acid is used as the catalyst as mentioned above, the reaction temperature is preferably lower than the thermal decomposition temperature or the vaporization temperature of the acid.

By the above-described reaction, the tetracarboxylic dianhydride(s) and the amine component (diamine(s) and tetramine(s)) are directly reacted to attain imidation, so that a polyimide is generated. Since the tetramine(s) serve(s) as a cross-linking agent, a cross-linked polyimide is formed. By the cross-linkage, large cyclic structures are thought to be formed. By virtue of the cross-linkage and the large cyclic structures, the polyimide according to the present invention gives a lower dielectric constant than those of the known linear polyimides. Formation of the cross-linkage and the large cyclic structures will be described later in the description of the production process of the copolymers synthesized by the sequential reactions.

The polyimide of the present invention may be a homopolymer (only one type of the tetracarboxylic dianhydride and the aromatic diamine are used, respectively), or may be a copolymer. Especially, forming a copolymer by sequential

reactions using a plurality of desired tetracarboxylic dianhydrides and/or a plurality of desired aromatic diamines is desired because desired properties or functions such as adhesiveness, dimensional stability and low dielectric constant may be given to the polyimide. Thus, in one preferred mode of the present invention, a polyimide copolymer is produced by sequential reactions (The polyimide copolymer produced by sequential reactions may be hereinafter referred to as "sequentially synthesized polyimide copolymer" for convenience).

To produce a sequentially synthesized polyimide copolymer, a tetramine, a tetracarboxylic dianhydride (A) and an aromatic diamine (B) are reacted by the above-described method to form an imide oligomer. The imide oligomer may be generated by the above-mentioned method employing a reaction time of usually about 60 to 120 minutes, preferably about 60 to 90 minutes. Then a tetracarboxylic dianhydride ($A_1$) and an aromatic diamine ($B_1$) are added and the resultant is allowed to further react. By such sequential reactions, a sequentially synthesized polyimide copolymer is formed. If desired, a third tetracarboxylic dianhydride ($A_2$) and a third aromatic diamine ($B_2$) may be added and reacted. Fourth or more tetracarboxylic dianhydride and/or aromatic diamine may also be added. In the final state, the molar ratio of the tetracarboxylic dianhydrides to the aromatic diamines is preferably 1:0.95 to 1.05. By carrying out the sequential reactions controlling the order of addition and the amounts of the compounds to be added, a desired sequentially synthesized polyimide copolymer having a large molecular weight may be generated.

Formation of an imide oligomer will now be described by way of an example. By reacting 1 mole of an H-shaped tetramine, 4 moles of a tetracarboxylic dianhydride and 4 moles of an aromatic diamine as shown in the reaction equation below, an imide oligomer [I] is generated.

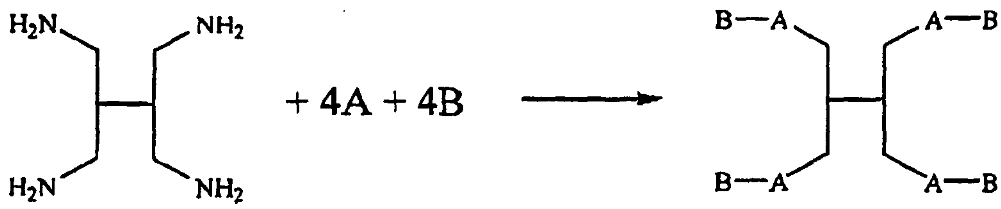


H-shaped tetramine

[I]

(wherein A represents a tetracarboxylic dianhydride and B represents an aromatic diamine).

By reacting 1 mole of an H-shaped tetramine, 8 moles of a tetracarboxylic dianhydride and 4 moles of an aromatic diamine as shown in the reaction equation below, an imide oligomer [11] is generated.

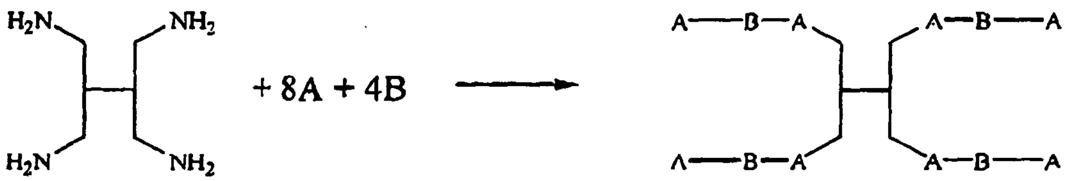


H-shaped tetramine

[II]

(wherein A represents a tetracarboxylic dianhydride and B represents an aromatic diamine).

The tetracarboxylic dianhydride and the aromatic diamine used in the generation of the imide oligomer [I] or [II] are not restricted at all. Preferred examples of the effective tetracarboxylic dianhydride include biphenyltetracarboxylic dianhydride (referred to as "BPDA"), pyromellitic dianhydride (referred to as "PMDA") and bis(dicarboxyphenyl)ether (referred to as "ODPA"). Preferred examples of the aromatic diamine effective for the generation of imide oligomer [T] or [II] include diaminotoluene (referred to as "DAT"), diaminodiphenyl ether (referred to as "DADE"), 9,9-(4-aminophenyl) fluorene (referred to as "FDA") and bis(4-aminophenoxy)-1,3-benzene (referred to as "mTPE").

The generated imide oligomer [I] or [II] is then sequentially reacted with a second tetracarboxylic dianhydride ($A_1$) and a second aromatic diamine ($B_1$), an intermediate copolymer [III] or [IV] is formed as follows:

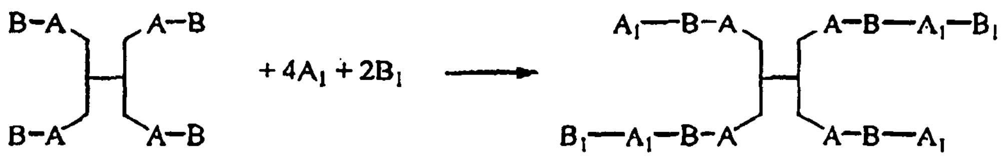

[I] [III]

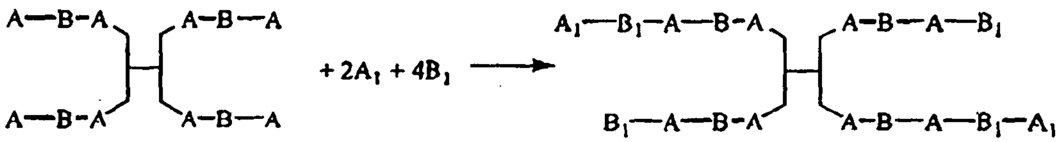

[II] [IV]

The above-described reactions arc basal reactions, and the following intermediate copolymer [V] or [VI], for example, may be generated as a modification of the above-described basal reactions.

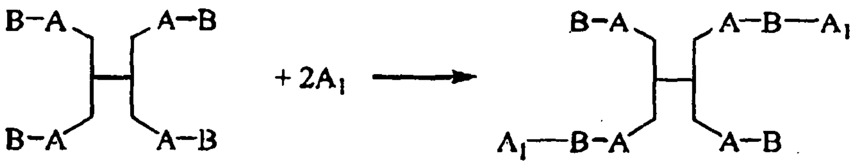

[I] [V]

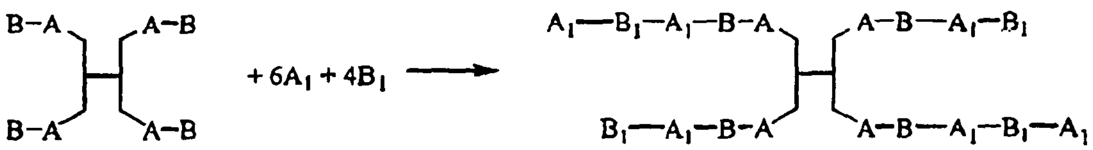

[I] [VI]

As described above, among the 4 terminals of the intermediate copolymer, 2 terminals may be constituted by the tetracarboxylic dianhydride residues and 2 terminals may be constituted by the aromatic diamine residues, by setting the difference between the number of moles of the tetracarboxylic dianhydride(s) and the number of moles of the aromatic diamine(s) to 2 moles, which are reacted per 1 mole of the H-shaped tetramine. The intermediate copolymer in which, among the 4 terminals, 2 terminals are tetracarboxylic dianhydridc residues and 2 terminals are aromatic diamine residues, such as intermediate copolymers [III] to [VI], is shown by the following formula [VII] for convenience.

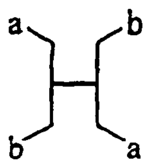

[VII]

(wherein a represents the terminal tetracarboxylic dianhydride residue and b represents the terminal aromatic diamine residue).

The intermediate copolymers are then reacted so as to form the cross-linked structure, thereby a cross-linked polyimide copolymer is formed. Further, along with the formation of the above-described cross-linked structure, large cyclic structures are thought to be formed as shown in the reaction equations below. The cyclic structures shown below are herein called "large cyclic" structures, in order to distinguish them from the cyclic structures such as benzene ring and piperazine ring contained in the monomer compounds *per se.*

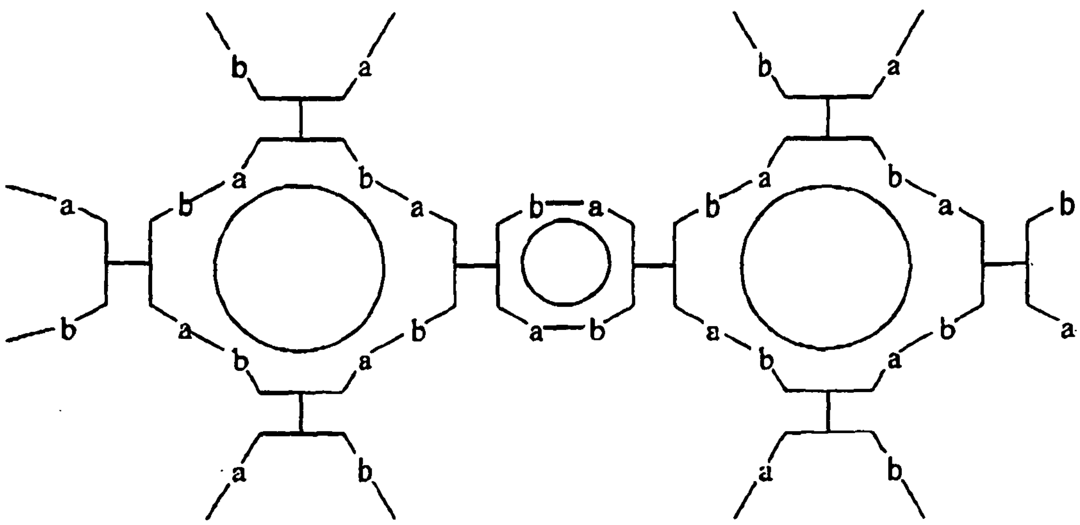

(wherein the circles are shown to emphasize the portions of the formed large cyclic structures, and do not represent the resonance double bond in aromatic ring or the like).

The conditions of the reaction to form the cross-linked large cyclic structures via the above-described intermediate copolymer, by sequentially reacting the above-described imide oligomer with the tetracarboxylic dianhydride(s) and aromatic diamine(s), are not restricted, and the reaction is usually and preferably carried out at 160°C to 200°C for about 3 hours to 15 hours. The catalyst and the reaction solvent to be used are as mentioned above.

In the generation of the cross-linked cyclic polyimide via the above-described intermediate copolymer, as the molecular weight increases, cross-linking and cyclization reactions co-occur so that the molecular weight distribution becomes broad to a Mw/Mn ratio of more than 2. The molecular weight distribution curve may exhibit a single peak or may exhibit 2 or more peaks.

Although the formation of the cross-linked large cyclic structures was described taking the cross-linked polyimide copolymer via the intermediate copolymer shown by the general formula [VII] as an example, in cases of homopolymers and even in cases where the number of moles of the tetracarboxylic dianhydride(s) and the aromatic diamine(s) added to per 1 mole of the imide oligomer are different from the number of moles exemplified above, polyimides having at least partially the cross-linked and large cyclic structures arc generated by the same mechanism as described above.

Although the solution of the cross-linked, cyclic polyimide is a uniform solution during the reactions, it is usually gelled when cooled to room temperature. The gel is converted to a solution with a low viscosity upon being heated again to 100°C to 180°C.

A polyimide solution stable at room temperature may be obtained by mixing and dissolving the cross-linked, large cyclic polyimide solution and a linear polyimide solution. Also, by generating the cross-linked cyclic polyimide in a linear polyimide solution, a liquid solution stable at room temperature may be obtained. The linear polyimide solution may be produced by carrying out the above-described production process according to the present invention except that the tetramine is not used. The production process *per se* of such a linear polyimide solution is known (U.S. Patent No. 5,502,143). In this case, the mixing ratio of the cross-linked polyimide to the linear polyimide in the mixed solution is not restricted and may be arbitrarily selected depending on the properties of the cross-linked polyimide and the linear polyimide used, and on the properties of the mixture desired. Usually, the ratio is about 20:80 to 80:20 by mole.

The composition containing the mixture of the cross-linked polyimide and the linear polyimide may also be produced, in addition to the above-mentioned method in which the produced cross-linked polyimide solution and the linear polyimide solution are mechanically mixed (the composition obtained by this method may be called "mechanically mixed polyimide composition" for convenience), by (1) a method in which (a) tetracarboxylic dianhydride(s) and (an)

aromatic diamine(s) are added to the cross-linked polyimide (or the intermediate copolymer) produced by the above-described process of the present invention so as to react them, and by (2) a method in which the production process of the present invention is carried out in a linear polyimide composition so as to generate a cross-linked polyimide. The composition containing both the cross-linked polyimide and the linear polyimide, which was produced by carrying out the polycondensation reaction in one of the polyimide compositions may also be called "mixed reaction type polyimide composition" for convenience. Since the mechanically mixed polyimide composition may be non-uniform, the mixed reaction type polyimide composition hereinbelow described in detail is preferred.

In the method (1), the tetracarboxylic dianhydride(s) and the aromatic diamine(s) later added react to generate linear polyimide, so that the composition becomes a mixture of the cross-linked polyimide and the linear polyimide. In this case, the cross-linked polyimide molecules and the linear polyimide molecules are thought to be intertwined with each other. In this method, the amount of the tetracarboxylic dianhydride(s) later added may be arbitrarily selected, and the mixing ratio of the cross-linked polyimide to the linear polyimide is usually about 20/80 to 80/20 by weight, preferably about 25/75 to 60/40 by weight. The reaction may be usually and preferably carried out at 160°C to 200°C for about 3 hours to 10 hours similar to the reactions mentioned above.

In the method (2), the production process according to the present invention using the tetramine is carried out in a linear polyimide solution, thereby generating the cross-linked polyimide. In this case, the linear polyimide solution may be produced by carrying out the above-described production process according to the present invention except that the tetramine is not used (U.S. Patent No. 5,502,143). The molecular weight of the linear polyimide is preferably 25,000 to 400,000 in terms of weight average molecular weight based on polystyrene, more preferably 30,000 to 200,000. The cross-linked polyimide molecules and the linear polyimide molecules arc thought to be intertwined with each other. The reaction may be usually and preferably carried out at 160°C to 200°C for about 3 hours to 10 hours similar to the reactions mentioned above. The amount of the tetramine(s) to be added may be appropriately selected, and is usually and preferably about 8/1 to 12/1 moles per 1 mole of the tetracarboxylic dianhydride(s) (in terms of monomers) constituting the linear polyimide.

The mixture of the cross-linked polyimide and the linear polyimide may also be generated by reacting larger amounts of (a) tetracarboxylic dianhydride(s) and (an) aromatic diamine(s) with respect to the tetramine(s) than those mentioned in the sequential synthesis reactions described above. Such a mixture is also within the scope of the present invention. That is, the composition obtained by this production process according to the present invention contains linear polyimide which was not cross-linked. To securely give the desired characteristics to the polyimide, the sequentially synthesized copolymers described above arc preferred.

A mechanically mixed polyimide solution containing the 2 types of polyimides and a mixed reaction type polyimide solution containing 2 types of polyimide are different in chemical and physical characteristics. Both the mechanically mixed polyimide and the mixed reaction type polyimide exhibit strong film characteristics. Polyimides dried at 180°C does not pass the PCT test (48 hours in saturated vapor at 120°C). Polyimide films dried at 220°C for not less than 2 hours pass the PCT test.

The cross-linked polyimide produced according to the present invention may be mixed with other crystalline engineering plastics to provide composite materials. Examples of the plastics include nylons, fluorine-contained resins, polyacetals, polyethylene terephthalates, liquid crystal polymers, polyetherether ketones, polyphenylene sulfides, polyarylates, polysulfones, polyether sulfones, polyether imides and polyamide imides. The cross-linked polyimide according to the present invention may be dissolved in a polar solvent together with (a) polymer(s) soluble in the polar solvent, such as nylons, fluorine-contained resins, liquid crystal polymers, polyamide imides, polyether imides, polycarbonates and polyurethanes, thereby modifying the engineering plastics.

By using the process of the present invention to provide a polyimide solution stable at room temperature, the processing thereof becomes easy so that films, multilayer substrates, laminates and the like may easily be produced by spin coating or casting method.

By blending a photoacid generator to the above-described cross-linked polyimide composition, a photosensitive polyimide composition is obtained. Photoacid generator is a compound which generates an acid upon being irradiated with light, and the polyimide is dissolved by this acid. Therefore, by making the polyimide composition in the form of a film, and selectively exposing the film through a photomask having a desired pattern, patterning of the film is attained. The technique *per se* to give photosensitivity to a polyimide composition by blending a photoacid generator was described in the prior patent application filed by the applicant and is known (WO99/19771). This technique may be applied to the composition produced by the present invention as it is.

That is, photoacid generator is a compound which generates an acid upon irradiation with light or electronic beam. Since the polyimide is decomposed by the action of the acid and is made soluble in alkalis, the photoacid generator employed in the present invention is not restricted and any compound which generates an acid upon irradiation with light or electron beam may be employed. Preferred examples of the photoacid generator include photosensitive quinone diazide compounds and onium salts.

Preferred examples of the photosensitive quinone diazide compounds include esters of 1,2-naphthoquinone-2-diazide-5-sulfonic acid and 1,2-naphthoquinone-2-diazide-4-sulfonic acid, the counterparts of the esters being low molecular aromatic hydroxyl compounds such as 2,3,4-trihydroxybenzophenone, 1,3,5-trihydroxybenzene, 2-methylphenol, 4-methylphenol and 4,4'-hydroxy-propane, but the photosensitive quinone diazide compounds are not restricted thereto.

Preferred examples of the onium salts include aryl diazonium salts such as 4(N-phenyl)aminophenyl diazonium salt; diaryl halonium salts such as diphenyl iodonium salt; triphenyl sulfonium salts such as bis{4-(diphenylsulfonio) phenyl}sulfide, and bis-hexafluoroantimonate, but the preferred onium salts are not restricted to these.

The photosensitive polyimide composition preferably contains the photoacid generator in an amount of 10 to 50% by weight based on the weight of the polyimide.

A patterned polyimide film may be obtained by casting a solution of the photosensitive cross-linked polyimide composition produced according to the present invention on a substrate, heating the cast solution at 60°C to 90°C to make the solution in the form a film, irradiating the film with light through a mask, and by forming positive image by etching the film with an alkaline solution. Usually, ultraviolet light is used, but high energy radiation such as X-ray, electronic beam or high power oscillation beam from an extra-high pressure mercury lamp may be employed. Although irradiation or exposure is carried out through a mask, the surface of the photosensitive polyimide layer may also be irradiated with the radiation beam. Usually, irradiation is carried out using a UV lamp which emits a light having a wavelength of 250 to 450 nm, preferably 300 to 400 nm. The exposure may be carried out using a single color ray or multiple color rays. It is preferred to use a commercially available irradiation apparatus, such as contact and interlayer exposing apparatus, scanning projector or wafer stepper.

After the exposure, by treating the photosensitive layer with a developer which is an aqueous alkaline solution, the irradiated regions of the photoresist layer can be removed, thereby a pattern is obtained. The treatment may be carried out by, for example, dipping the photoresist layer or spraying the developer under pressure to the photoresist layer so as to dissolve the exposed regions of the substrate. Examples of the alkali to be used as the developer include, although not restricted, aminoalcohols such as aminoethanol, methyl morpholine, potassium hydroxide, sodium hydroxide, sodium carbonate, dimethylaminoethanol, hydroxytetramethyl ammonium and the like. Although the concentration of the alkali in the developer is not restricted, it is usually about 30 to 5% by weight.

The development time varies depending on the energy of exposure, strength of the developer, manner of development, preheating temperature, temperature of the treatment with the developer and the like. Usually, with the development by dipping, the development time is about 1 to 10 minutes, and with the development by spraying, the development time is usually about 10 to 60 seconds. The development is stopped by dipping the developed layer in an inactive solvent such as isopropanol or deionized water, or by spraying such a solvent.

By using the positive-type photosensitive polyimide composition produced according to the present invention, polyimide coating layers having a layer thickness of 0.5 to 200 $\mu$m, and relief structures having sharp edges may be formed.

By incorporating units containing anionic groups as a part of the units constituting the cross-linked polyimide described above in detail, the polyimide may be deposited by electrodeposition. The anionic group is a group which becomes an anion in the solvent (described Jater) of the electrodeposition component, and is preferably carboxylic group or a salt thereof. Although the siloxane-containing diamine or the tetracarboxylic dianhydride component may have the anionic group, it is preferred to use a diamine having an anionic group as a part of the diamine component. To promote the heat resistance, adhesiveness with the material serving as the base of the electrodeposition, and the polymerization degree, the anionic group-containing diamine is preferably an aromatic diamine. Examples of such an anionic group-containing aromatic diamine include aromatic diaminocarboxylic acids such as 3,5-diaminobenzoic acid, 2,4-diaminophenyl acetic acid, 2,5-diaminoterephthalic acid, 3,3'-dicarboxy-4,4'-diaminodiphenylmethane, 3,5-diamino-*p*-toluic acid, 3,5-diamino-2-naphthalene carboxylic acid and 1,4-diamino-2-naphthalene carboxylic acid, and 3,5-diaminobenzoic acid is especially preferred. The anionic group-containing aromatic diamine may be used individually or a plurality of anionic group-containing aromatic diamines may be used in combination. In cases where the siloxane-containing diamine has the anionic group, the diamine component may be the siloxane-containing diamine alone. In cases where the polyimide has the anionic group, the content of the units having the anionic group is preferably about 10 to 70 mol% in the polyimide molecule.

Electrodeposition may be carried out by immersing a copper foil (positive electrode) to be coated by electrodeposition and a stainless steel (negative electrode), and by passing electric current between the electrodes from a direct-current power source.

Further, by adding the above-described photoacid generator to the polyimide composition for electrodeposition, positive image may be formed by conducting photolithography after the electrodeposition.

Cross-linked polyimide is non-crystalline and has an excellent adhesiveness and good dimensional stability. By virtue of the cross-linked structure, the cross-linked polyimide has a high chemical resistance such as resistance to cracking and has resistance to thermal decomposition. It has a high tensile strength, but the tear resistance is low. The polyimide film prepared from the polyimide produced by generating the cross-linked cyclic polyimide in a linear large molecular polyimide solution has a sufficient tensile strength and tear strength, and also has an excellent weatherability.

Exploiting these characteristics, it may be used for multilayer substrates, laminates, protection of inside of oil pipelines and solar cells, and as surface protection films.

The cross-linked polyimide produced according to the present invention having a dielectric constant of not more than 2.7, preferably 1.9 to 2.2, may preferably be used for electrical or electronic equipments or parts thereof as insulation materials, insulating substrates and protection materials. The present invention can thus be used to provide an electrical or electronic equipment or a part thereof, which comprises an insulation material, insulating substrate or protection material, that contains the cross-linked polyimide having a dielectric constant of not more than 2.7. Here, the insulation materials, insulating substrates or the protection materials include (1) interlayer insulation films of semiconductor elements, (2) laminate sheets, multilayer circuit substrates and flexible copper-clad plates, and (3) semiconductor chip-coating films. The semiconductor chip coating films include passivation films, α-ray-blocking films and buffer coat films. These will now be described in more detail.

(1) About Low Dielectric Interlayer Insulation Films

Interlayer insulation film is the insulation film which electrically separates the interconnection layers of multilayer interconnection of LSI and the like. Polyimides which are excellent in insulation properties as well as in heat resistance and chemical resistance (resistance to soldering heat) are used. However, KAPTON (trademark) and Upilex (trademark) which are usual polyimides have a dielectric constant of about 3.3. Thus, along with the demand of high precision processing, a polyimide with lower dielectric constant is demanded.

The low dielectric cross-linked polyimide provided by in the present invention may have a dielectric constant of not more than 2.7, especially 1.9 to 2.3 while retaining the characteristics of polyimides. By using this low dielectric film as the interlayer insulation film of semiconductor elements and multilayer interconnection sheets, excellent electric characteristics may be attained by virtue of the low dielectric constant and high withstand voltage, and the performance is promoted by the reduction of the signal propagation delay and the like. Semiconductor element herein means (i) integrated circuit elements of semiconductor compounds, (ii) hybrid integrated circuits, (iii) light emitting diodes, (iv) charge-coupled devices and the like. More particularly, it means discrete semiconductors such as diodes, transistors, compound semiconductors, thermistors, varistors and thyristors; memory elements such as DRAM (dynamic random access memory), SRAM (static random access memory), EPROM (erasable programmable read only memory), mask ROM (mask read only memory), EEPROM (electrical erasable programmable read only memory) and flash memory; theoretical circuit elements such as microprocessor, DSP (digital signal processor) and ASIC (application specific integrated circuit); integrated circuit elements of compound semiconductors represented by MMIC (monolithic microwave integrated circuit); hybrid integrated circuits (hybrid IC); light emitting diodes; photoelectric conversion elements such as charge-coupled devices; and the like.

The coating methods of the polyimide composition when preparing an interlayer insulation film include spin coating method, dipping method, potting method, die coating method, spray coating method and the like, and the coating method may be appropriately selected depending on the shape of the product to be coated, the required film thickness and the like. When applying the polyimide composition to the insulation films between semiconductor elements, spin coating method is preferred because of the uniformity of the film thickness. When applying the polyimide composition to the interlayer insulation films of multilayer interconnection sheets, spin coating method, as well as die coating method which gives higher yield, is preferred.

(2) About Laminates and Multilayer Circuit Substrates

The polyimide may be used as the heat resistant low dielectric polyimide insulation films which are used for printed circuit boards of electronic equipments and slot insulation of rotary machines. Since plastic films have high insulation performance, they are used in electronic and electrical equipments for cable covering insulation, insulation of printed circuit boards and slot insulation of rotary machines as parts for which reliability is required. In the history of the development of such plastic insulation films, films of plastics having excellent environment resistance, particularly, engineering plastics having excellent heat resistance were developed. As the electronic parts of film capacitors and the like, in addition to the development of heat resistant plastics, materials having a high dielectric constant were developed to attain the higher capacitance. Recently, for electronic equipments for storing large amount of information, processing and transferring the information with high speed, corresponding to the advanced information society, high performances of plastic materials are also demanded. Particularly, as an electric characteristic corresponding to the increase in the frequency, lower dielectric constant and lower dielectric loss tangent are demanded. In the equipments having rotary machines such as motor, inverter control is carried out so as to attain precise control for attaining high efficiency and advanced functions. Since leak current of high frequency component at the insulation material is increased, lower dielectric constant for preventing it is demanded as an electric characteristic.

Since the cross-linked polyimide produced in the present invention has a dielectric constant of as low as not

more than 2.7, while retaining the excellent electric insulation performance, dimensional stability, chemical resistance and the like intrinsic to the polyimides, power consumption and speeding up of the signal transfer may be attained by using the polyimide for the multilayer circuit substrates such as multilayer printed boards, and laminates.

(3) Substrates of Flexible Copper-clad Plates

Low dielectric flexible copper-clad plates match the miniaturization and weight saving of electronic equipments because of their flexibility, light weights and slimness, so that its demand is sharply increased.

As the material of the flexible copper-clad laminate plates, polyimides having excellent characteristics and polyesters having general characteristics are mainly used, and glass and epoxy resins are used in part. Fully aromatic polyimide films are stable at from extremely low temperature to ultrahigh temperature, that is, from -269°C to +400°C, and has the highest heat resistance and cold resistance in plastics. In the recent main trend, parts are directly mounted on the flexible circuit sheets similar to the rigid circuit boards. After mounting parts such as semiconductor chips, capacitors and resistors, the plates are exposed to a high temperature of 240°C to 270°C in the solder reflowing step. As a material which withstands the high temperature, polyimides are the best.

Since the cross-linked polyimide provided by the present invention is a solution of the polyimide produced by direct imidation, the processability is good. Further, since it has a low dielectric constant, it is excellent as a copper-clad substrate for precision processing.

Flexible circuit boards include those having trilayer structure and bilayer structure. Trilayer flexible circuit boards (hereinafter also referred to as "trilayer FPC" or "trilayer flex") have a constitution wherein a polyimide film is laminated with a copper foil through an adhesive. Flexible circuit boards having bilayer structure (hereinafter also referred to as "bilayer FPC" or "bilayer flex") do not use an adhesive, and constituted only by copper foil and polyimide film.

(A) Production Process of Bilayer Flex

Bilayer flex are produced by various processes. Production processes of bilayer flex include casting method in which a polyimide precursor varnish is applied on a copper foil and the varnish is dried and cured; sputtering method and plating method in which copper is deposited on a polyimide film. In the casting method, not only electrolyzed copper foil (the surface thereof is irregular and is suited for adhesion), but also rolled foil and other various metal foils may be used as the copper foil. The bilayer FPC produced by the casting method is excellent in the adhesiveness between the polyimide film and the copper, as well as in heat resistance, flame resistance, electric characteristics and chemical resistance. The sputtering method and plating method are characterized in that the thickness of the copper can be arbitrarily controlled. By making the copper layer very thin, fine patterns of very thin lines may easily be prepared. However, since copper is deposited on the known smooth polyimide film, there is a problem in that the adhesion between the copper and the film is somewhat weak.

(B) Features of Bilayer Flex

Since trilayer FPCs have an adhesive, there is a problem in that the adhesive is deteriorated by a heat treatment for a long time so that the reliability is degraded even if it can withstand a heat treatment for a short time. Further, because of the adhesive layer, there is a problem of migration of copper and penetration of plating solution. In contrast, since an adhesive is not used in the bilayer FPC, it is free from all of the above-mentioned drawbacks.

Bilayer FPC has the following features: That is, it has an excellent heat resistance and is resistant to flame. The dielectric constant and the dielectric loss tangent are small, and frequency dependency and temperature dependency are small. Surface resistivity and volume resistivity are large, and it is stable to various treatments. Contents of ionic impurities arc small and the reliability is high. The rate of dimensional change is small and the rates of change in both the X- and Y-axis directions are about the same. Thermal deterioration of peel strength is small. Wire bonding can be easily carried out. Thus, bilayer FPCs have very high performances, and are is used for hard disk drives, flexible disk drives, printers and the like, in which high flexibility is demanded. Further, they are used in engine rooms of automobiles, for which high heat resistance is demanded, and for level sensors in gasoline tanks and the like, for which chemical resistance is demanded.

When a conventional polyimide of the type of KAPTON (trademark) is used, polyamic acid which is a precursor of polyimide is applied on the copper foil, and the copper-clad plate is prepared by heating the laminate to a temperature of not lower than 300°C. Adhesiveness and processability are problematic, and the phenomenon of migration is observed.

In contrast, using the composition prepared by the present invention, the substrate of flexible copper-clad plate may be prepared by casting an already imidized varnish on the copper substrate, and a treatment at a low temperature of 250°C is sufficient. The polyimide has advantages in that it has a low dielectric constant of 1.9 to 2.3 and is suited for fine processing, and migration of copper is hardly observed.

Development of Techniques for Preparing Multilayer Flexible Circuit Boards

In response to the miniaturization and commercial functionalization of electronic equipments, high density mounting and high reliability of flexible circuit boards are demanded, and the number of layers has been actively increased. In particular, rigid flex multilayer interconnection boards and all flex multilayer interconnection boards have been widely used in various fields because they have not only the down-sizing effects, but also prominent effects in the promotion of reliability and saving in total costs.

It is thought that the number of layers in flexible circuit boards will be more and more increased, and those having not less than 10 layers will be produced. In that case, it is thought that the thickness per one layer will be 0,1 mm or less, the interconnections will become fine such that the number of interconnections between IC pins will be not less than 5, and that diameters of through holes will be not more than 0.3 mm.

Polyimide for Semiconductor Chip Coating

The tasks in technology developments in the semiconductor field are to attain higher integration of semiconductor devices, promotion of productivity of the production steps of devices, and safety and no pollution in working environment. Large scale production of 256M bit DRAM has started, the sizes of the chips have been enlarged, and the aluminum interconnection circuits have been made more and more fine. Along therewith, promotion of the reliability of semiconductor devices has become a more and more important task. For the promotion of productivity, the wafer size has been enlarged, and reduction of number of production steps of semiconductors and promotion of the yields by prevention of the damages of the chips during handling have become the tasks. Further, along with the trend in the surface mounting of semiconductor devices, protection of the surface of the semiconductor elements has also become an important task.

To attain these tasks, polyimides are used in large amounts. The reasons therefor are that the polyimides have prominent effects in (1) the prevention of sliding of fine aluminum circuits on the surface of elements and cracking of packages due to the shrinkage on curing of the scaling resin or thermal shock during surface mounting, (2) prevention of cracking of inorganic passivation films made of silicon oxide or the like at the surface of chips, and (3) the prevention of disconnection due to the interlayer insulation of the multilayer aluminum circuits and planarization of the circuit steps at the surface of elements. Main uses of polyimides for coating semiconductors are as follows:

<Passivation Films>

Passivation films having a thickness of 25 μm are formed on the surfaces of elements. The object of forming a passivation film is to prevent contamination of the surface of the element, thereby stabilizing the surface of the element. At first, inorganic materials were used. Later, polyimides having good covering properties, free from coating defects such as pinholes, and having good ease of handling came to be used. However, recently, for VLSIs demanding a very high level of moisture resistance, the moisture resistance of polyimides is insufficient, so that inorganic passivation films have again been used. On these inorganic passivation films, polyimides are used as buffer coat films described below.

<α-ray-blocking Films>

The α-ray emitted mainly from uranium and thorium contained in the inorganic fillers in the plastic moldings inverts the electric charge of the element so as to cause malfunction of the memorized information. This phenomenon is called soft error. Along with the speeding up of the elements, the cell areas were decreased and the information-carrying current was decreased. Because of these, the risk for causing soft errors has become higher and higher. As a countermeasure against the malfunction of the memories caused by α-ray, it is effective to form polyimide protection films on the chips so as to block α-ray. A, protection film having a thickness of about 50 μm drastically decreases the soft error ratio. The reason why the polyimides are effective as the α-ray-blocking films is that the contents of uranium and thorium therein are as small as 0.03 ppb or less.

<Buffer Coat Films>

Semiconductor devices are exposed to a hot molten solder during surface mounting. During this, semiconductor devices receive thermal stress due to the heat expansion of the sealing material, so that the inorganic passivation films (e.g., phosphosilicatc glass (PSG)) are pressed to form cracks therein. This results in invasion of moisture into the element, which makes the element defective. To prevent the concentration of the stress at the interface between the sealing material and the inorganic passivation film, it is necessary to form a buffer layer at the interface. By forming a polyimide film with a thickness of 2 to 3 μm as a buffer layer on the PSG film, the anti-moisture reliability after immersion

into solder is largely promoted.

<Interlayer Insulation Films>

One of the methods for highly integrating semiconductor devices is the multilayer technology. When an inorganic material (e.g., CVD-$SiO_2$ (chemical vapor deposition-$SiO_2$) is used as an interlayer insulation film between the interconnection on the first layer and that in the second layer, since the inorganic material is deposited to a uniform thickness on any portion, the steps due to the interconnection on the first layer are retained on the interlayer insulation film, thereby giving uneven structure, As a result, the interconnection on the second layer formed on this film is likely to be broken at the shoulder portions of the steps. In contrast, by using an organic material such as polyimide as the interlayer insulation film, the stepwise shape of the upper portion of the interconnection on the first layer is flattened due to the flowability of the polyimide. As a result, steps are not formed in the interconnection on the second layer formed thereon, so that the possibility of disconnection is eliminated.

Types and Features of Polyimides for Chip-coating

Using a macromolecular compound as the insulation films has been attempted since 1970s in the United States. However, this was not employed practically because of the insufficient heat resistances of the macromolecular compounds and because of the high contents of ionic impurities therein. In 1973, polyimide isoindoloquinazoline dione (PID) was developed by Hitachi Seisakusho, and PID was used as the first macromolecular compound in a part of semiconductor elements. A macromolecular insulation film for semiconductors must have the following characteristics: (1) heat resistance sufficient for withstanding the heat treatments during production, (2) good adhesiveness to the base material (inorganic films, organic sealing materials and the like) to be coated, and (3) low contents of ionic impurities so that the characteristics of the semiconductor are not deteriorated. Other desired characteristics include low expansion coefficient, low stress, low water-absorption, low dielectric constant, good workability for coating, ease of fine processing, formability of thick film and curability at low temperature.

Polyimides are the resin which best satisfy the above-described demanded characteristics. Polyimides are excellent in heat resistance, electric characteristics and mechanical characteristics, the contents of ionic impurities therein are low, and they have good processability for forming patterns.

The advantages of using the cross-linked polyimide as the chip-coating film are that its dielectric constant is low, adhesiveness is excellent and that migration is not observed. In addition to the advantages in processability, it has excellent characteristics when compared to the conventional polyimides.

The present invention will now be described in detail by way of some examples. Since various characteristic polycondensed polyimides are obtained by various combinations of acid dianhydrides and aromatic diamines, the present invention is not restricted to these examples.

An aliquot of the solution obtained in each Example was diluted in dimethylformamide and the molecular weight and distribution thereof were measured by high performance liquid chromatography (produced by TOSOH). Most frequent molecular weight (M), number average molecular weight (Mn), weight average molecular weight (Mw) and Z average molecular weight (Mz) are described. The molecular weights based on polystyrene are described. The distribution and cross-linkage are shown in terms of Mw/Mn and Mz/Mn.

Thermal analysis was carried out by using a thermal analysis apparatus GTA-50 produced by SHIMADZU CORPORATION, and the decomposition temperatures at which 5% and 10% of the polyimide is decomposed, respectively, and the ratio of residue (%) at 600°C are described.

Infrared absorption spectrum was measured using an infrared analysis apparatus Spectral produced by PERKIN ELMER The absorption at 1785 $cm^{-1}$ is that of imide bond, the absorption at 1720 $cm^{-1}$ is that of -CO-NH- bond, and oxazole has an absorption at 1651 $cm^{-1}$.

The dielectric constants of polyimide films were measured using a precision LCR meter, 4285A (product of AGILENT). To promote the accuracy of the reading of the electrode for measuring electric constant, the micrometer was changed to digital type such that the film thickness was able to be read up to 1 μm. The measurement was carried out in accordance with the instructions by the manufacturer. The thicknesses of the polyimide films were not less than about 50 μm, and the dielectric constants were measured at frequencies (kHz) of 75, 100, 200, 300, 500, 800, 1000, 2000, 3000 and 5000. The measured dielectric constants and tangent delta are described.

Example 1

To a three-necked separable flask equipped with a stainless steel anchor agitator, a condenser comprising a trap for water separation and a cooling tube having balls was attached. While blowing nitrogen at a rate of 500 ml/min, the flask was immersed in a silicone oil bath to heat the flask, the content therein being stirred.

10.92 g (0.03 mol) of BDP (molecular weight: 364-39), 35.31 g (0.12 mol) of biphenyltetracarboxylic dianhydride (molecular weight: 294.22) (referred to as "BPDA"), 3,4'-diaminodiphenyl ether (0.12 mol) (molecular weight: 200.2), 1.35 g of oxalic anhydride, 4.8 g of pyridine, 450 g of N-methylpyrrolidone (referred to as "NMP"), and 50 g of toluene were added, Under nitrogen flow, the mixture was stirred at 180 rpm at 180°C for 60 minutes, and the mixture was air-cooled (30 minutes). To the mixture, 37.23 g (0.12 mol) of bis-(dicarboxyphenyl)-sulfone dianhydride (referred to as "ODPA") (molecular weight: 312.22), 4,4'-diaminophenoxy-1,3-benzene (referred to as "mTPE") (0.06 mol) (molecular weight: 292.3), 531 g of NMP and 50 g of toluene were added, and the resulting mixture was heated at 160°C under stirring at 180 rpm for 6 hours and 10 minutes. A polyimide solution of 10% was obtained. The obtained mixture was gelled after being left to stand overnight. Molecular weight (based on polystyrene) was measured by GPC. M=32,600, Mn=13,600, Mw=53,500, Mz=127,100, Mw/Mn=3.9, Mz/Mn=9.3. In measurement of thermal decomposition, 5% of the polymer was decomposed at 485°C.

Example 2

Operations similar to Example 1 were carried out.

That is, 7.28 g (0.02 mol) of BDP, 23.52 g (0.08 mol) of BPDA, 30.76 g (0.08 mol) of 9,9'-bis-(4-aminophenyl) fluorene (referred to as "FDA"), 0,90 g of oxalic anhydride, 3.2 g of pyridine, 261 g of NMP and 50 g of toluene were added, and the mixture was heated at 180°C under stirring at 170 rpm for 90 minutes. After air-cooling the mixture, 24.8 g (0.08 mol) of ODPA, 11.22 g (0.04 mol) of bis(3,3'-diamino-4,4'-dihydroxydiphenyl)sulfone dianhydride (referred to as "HO-$SO_2$AB"), 261 g of NMP and 30 g of toluene were added, and the resulting mixture was allowed to react at 180°C, 165 rpm for 7 hours to obtain a polyimide solution with a concentration of 15% by weight. The obtained solution was gelled after being left to stand overnight, M=21,700, Mn=12,600, Mw=28,900, Mz=55,800, Mw/Mn=2.30. The thermal decomposition temperature was measured. The temperatures at which 5% and 10% of the polyimide was decomposed were 388°C and 480°C, respectively. The percent residue at 600°C was 76%.

Example 3

Operations similar to Example 1 were carried out.

That is, 10.92 g of BDP, 35.31 g of BPDA, 24.0 g of 3,4'-diaminodiphenyl ether (referred to as "mDADE") (molecular weight: 200,2), 1.35 g of oxalic anhydride, 4.8 g of pyridine, 450 g of NMP and 50 g of toluene were added. Under nitrogen flow, the mixture was heated at 180°C under stirring at 180 rpm for 90 minutes. After air-cooling the mixture, 37.23 g of ODPA, 51 g of diaminosiloxane (above-described structural formula (8), amine number: 425), 120 g of toluene and 399 g of NMP were added. In this operation, diaminosiloxane and toluene were first added, and then ODPA and NMP were added. Gels were generated immediately. By stirring the mixture at 180°C, 20 rpm for 20 minutes, the mixture became a uniform solution. The mixture was then heated at 180°C under stirring at 170 rpm for 10 hours and 20 minutes to obtain a polyimide solution with a concentration of 23.2%. The mixture was in the form of gel at room temperature. Molecular weight was measured by GPC, M=18,000, Mn=11,800, Mw=39,800, Mz=122,000, Mw/Mn=3.37. By thermal analysis, 5%- and 10%-decomposition temperatures were 461°C and 482°C, respectively, and the percent residue at 600°C was 58%.

Example 4

Operations similar to Example 1 were carried out.

That is, 10.92 g of BDP, 35.31 g of BPDA, 24.0 g of m-DADF, 1.35 g of oxalic anhydride, 4.8 g of pyridine, 450 g of NMP and 50 g of toluene were added. The mixture was heated at 180°C under stirring at 180 rpm for 60 minutes, and air-cooled. To the mixture, 51 g of diaminosiloxane (above-described structural formula (8), amine number: 425), 120 g of toluene were added, and then 37.23 g of ODPA and 399 g ofNMP were added. Ten minutes later, since gels were precipitated, the mixture was slowly stirred at 180°C for 20 minutes, and the mixture became a solution. The solution was heated at 180°C under stirring at 160 rpm for 10 hours and 20 minutes to obtain a polyimide solution with a concentration of 23.2%. The mixture was gelled at room temperature. Molecular weight was measured by GPC. M=16,500, Mn=9,100, Mw=17,600, Mz=27,800, Mw/Mn=1.94. By thermal analysis, 5%- and 10%-decomposition temperatures were 437°C and 470°C, respectively, and the percent residue at 600°C was 56%.

Example 5

Mixed reaction was conducted. Operations similar to Example 1 were carried out.

Preparation of Linear Polyimide Solution

62.044 g (0.02 mol) of ODPA, 12.22 g (0.01 mol) of diaminotoluene, 2 g of valerolactone, 4 g of pyridine, 30 g of NMP and 50 g of toluene were added. The mixture was allowed to react at 180°C, 165 rpm for 90 minutes. After air-cooling the mixture, 29.42 g (0.01 mol) of BPDA, 69.60 g (0.02 mol) of 9,9'-bis(4-aminophenyl)fluorene, 350 g of NMP and 50 g of toluene were added, and the resulting mixture was stirred at room temperature for 30 minutes. Thereafter, 200 g of NMP was added and the resulting mixture was allowed to react at 175°C, 170 rpm for 4 hours and 20 minutes to obtain a linear polyimide solution having a concentration of 15% by weight. Molecular weight was measured by GPC. M=50,300, Mn=26,600, Mw=54,300, Mz=90,900, Mw/Mn=2.14, Mz/Mn=3.41.

A 100 g aliquot of the thus obtained linear polyimide solution (15%) was taken, and the same components as in Example 3 were polycondensed.

That is, 1.21 g of BDP, 3.92 g of BPDA, 2.67 g of m-DADE, 0.4 g of valerolactone, 0.8 g of pyridine, 50 g of NMP and 30 g of toluene were added, and the resulting mixture was stirred at room temperature. After making the mixture uniform solution, the solution was heated at 180°C under stirring at 170 rpm for 90 minutes. After air-cooling the mixture, 5.7 g of diaminosiloxanc (above-described structural formula (8), amine number: 425) and 30 g of toluene were added, and then 4.14 g of ODPA and 50 g ofNMP were added. The flask was immersed in a bath at 180°C for 10 minutes while stirring the mixture at 160 rpm, and the mixture became a solution. The solution was heated at 180°C under stirring at 165 rpm for 4 hours and 35 minutes. The solution was in the form of solution even after being cooled to room temperature. Molecular weight was measured by GPC. M=33,300, Mn=17,700, Mw=52,100, Mz=114,100, Mw/Mn=2.94. By thermal analysis, 5%-and 10%-decomposition temperatures were 461°C and 485°C, respectively, and the percent residue at 600°C was 72%.

Example 6

Mixed reaction between the polyimide having the similar composition to Example 3 and a linear polyimide was carried out.

That is, 3.64 g of BDP, 11.77 g of BPDA, 8.0 g of m-DADE, 0.8 g of valerolactone, 1.6 g of pyridine, 150 g of NMP and 30 g of toluene were added, and the mixture was allowed to react at 180°C, 160 rpm for 60 minutes under nitrogen. After allowing the mixture to cool to room temperature, 12.41 g of ODPA, 17.0 g of diaminosiloxane (above-described structural formula (8), amine number: 425), 60 g of toluene and 135 g of NMP were added, and gels were generated. The mixture was stirred at 180°C, 170 rpm for 20 minutes, and the mixture became a uniform solution. The solution was allowed to react at 180°C,165 rpm for 6 hours and 45 minutes. The obtained polyimide mixed reaction solution was liquid at room temperature. Molecular weight was measured by GPC. M=18,000, Mn=11,800, Mw=39,400, Mz=122,000, Mw/Mn=3.37, Mz/Mn=10.3. By thermal analysis, 5%-and 10%-decomposition temperatures were 461°C and 482°C, respectively, and the percent residue at 600°C was 58%. A 100 g aliquot of this solution (concentration: 15% by weight) was taken, and subjected to mixed reaction by adding the following compounds:

That is, 6.02 g of ODPA, 1.22 g of diaminotoluene, 0.4 g of valerolactone, 0.8 g of pyridine, 30 g of NMP and 30 g of toluene were added, and the obtained mixture was allowed to react at 180°C,170 rpm for 60 minutes. After air-cooling the mixture, 2.94 g of BPDA, 6.96 g of FDA, 35 of NMP and 30 g of toluene were added, and the resulting mixture was allowed to react at 180°C, 165 rpm for 4 hours and 25 minutes. The molecular weights of this mixed reaction solution were as follows: M=71,900, Mn=28,400, Mw=75.800, Mz=132,300, Mw/Mn=2.66, Mz/Mn=6.15. This polyimide was made into a film and subjected to thermal analysis. 5%- and 10%-decomposition temperatures were 475°C and 504°C, respectively, and the percent residue at 600°C was 75%.

Example 7

The linear polyimide (concentration: 15% by weight) synthesized in Example 5 and the cross-linked polyimide (concentration: 15% by weight) containing the tetramine, synthesized in Example 6 were mixed in an amount of 100 g each, and the mixture was stirred. As a result, the mixture was liquid at room temperature.

Example 8

To the flask, 3.64 g of BDP, 11.77 g of BPDA, 8.0 g of m-DADE, 0.45 g of oxalic anhydride, 1.6 g of pyridine, 150 g of NMP and 30 g of toluene were added, and the mixture was allowed to react at 180°C, 165 rpm for 60 minutes under nitrogen, After allowing the mixture to cool to room temperature, 11.77 g of BPDA, 17.0 g of diaminosiloxane (amine number: 425), 60 g of toluene and 84 g NMP were added and the mixture was stirred to dissolve the gels. This solution was allowed to react at 180°C, 165 rpm for 5 hours and 30 minutes. The solution was allowed to cool to room

temperature, and the solution was gelled. Molecular weight was measured by GPC. M=16,500, Mn=9,100, Mw=17,600, Mz=27,800, Mw/Mn=1.94, Mz/Mn=3.05. Thermal analysis was carried out. The 5%- and 10%-decomposition temperatures were 437°C and 470°C. respectively, and the percent residue at 600°C was 56%.

Example 9

Each of the polyimide solutions prepared in Examples 1-8 was applied on a glass plate with a bar coater, and the resultant was heated at 90°C for 90 minutes in an infrared oven. The polyimide film was peeled off from the glass plate, and mounted on a stainless steel frame, followed by fixing the film with a cap. The film was then heated at 180°C for 2 hours and then at 220°C for 1 hour in an infrared oven The thickness of the polyimide film was not less than about 50 μm. The dielectric constant was measured using a precision LCR meter, 4285 produced by AGILENT. The dielectric constants at 1000 kHz and 3000 kHz, and tan δ are shown in Table 1.

Table 1

| Example | Film Thickness μm | Dielectric Constant | | tangent delta | |
|---|---|---|---|---|---|
| | | 100bkHz | 3000kHz | 1000kHz | 3000kHz |
| Example 1 | 48 | 2.36 | 2.33 | 0.0124 | 0.0128 |
| Example 2 | 64 | 2.65 | 2.60 | 0.0209 | 0.0223 |
| Example 3 | 54 | 2.10 | 2.06 | 0.0043 | 0.0072 |
| Example 4 | 65 | 2.06 | 2.04 | 0.0052 | 0.0050 |
| Example 5 | 74 | 1.95 | 1.94 | 0.0055 | 0.0065 |
| Example 6 | 61 | 2.21 | 2.19 | 0.0106 | 0.0125 |
| Example 7 | 58 | 2.45 | 2.43 | 0.0074 | 0.0085 |
| Example 8 | 65 | 2.06 | 2.04 | 0.0050 | 0.0052 |

The relationships between the frequency (kHz), dielectric constant and tangent delta are shown for the polyimides of Examples 1 and 8, $SiO_2$ and the air are shown in Figs. 1-4, respectively.

Synthesis Examples of Tetramines

A) Bis(3,5-diaminobenzoyl)-1,4-piperazine

To a separable flask, 134 g of 3,5-diaminobenzoic acid, 34.4 g of piperazine, 51 g of NMP and 40 g of toluene were added, and the mixture was heated at 160°C under stirring at 170 rpm for 2 hours under nitrogen, using the same apparatus as used in Example 1. The mixture was left to stand overnight and crystals precipitated. The crystals were filtered with suction and washed with ethanol.

B) Bis(3,5-diaminobenzoyl)-4,4'-diaminodiphcnyl ether

To a three-necked flask, 10.1 g of 3,5-dinitrobenzoyl chloride, 4.0 g of 4,4'-diaminodiphenyl ether, 60 g of NMP and 40 g of toluene were added, and the mixture was heated at 150°C under stirring at 165 rpm for 3 hours. The mixture was left to stand overnight and crystals precipitated. The crystals were filtered and washed with ethanol (12.2 g).

To a solution containing 11.8 g of the generated bis[3,5-dinitrobenzoyl]-4,4'-diaminodiphenyl ether and 70 g of methoxypentanol, 0.2 g of Pd/C was added, and then 4.5 g of hydrazine monohydrate ($NH_2 \cdot NH_2 \cdot H_2O$) was slowly added (2 hours) while stirring the mixture at 130°C. The mixture was left to stand overnight and crystals precipitated. The crystals were filtered and washed with ethanol.

C) Bis[3,5-diaminophenyl]-2,2'-oxazol-diphenyl sulfone

To a three-necked flask, 50 g of 3,5-dinitrobenzoyl chloride, 24.1 g of bis(3-amino-4-hydroxyphenyl)sulfone, 170 g of NMP, 30 g of toluene and 10 g of pyridine were added. The mixture was heated at 150°C under stirring at 160 rpm for 2 hours and 30 minutes. After the reaction, methanol and water were added and the mixture was left to stand to form precipitates. The precipitates were filtered and washed with ethanol (73.6 g).

The generated bis(3,5-dinitrophenyl)-2,2'-oxazol-diphenyl sulfone was dissolved in NMP and Pd/C was added thereto. The mixture was then reduced with hydrazine monohydrate at 130°C, and methanol and water were added after filtration to form precipitates. The precipitates were filtered and washed with methanol.

D) 2,7-diamino-9,9'-di(4-aminophenyl)-fluorene

37.3 g of 2,7-dinitrofluorene, 8.6 g of *p*-toluenesulfonic acid, 130 ml of sulfolane and 30 ml of toluene were added, and the mixture was heated at 140°C for 90 minutes under stirring. The reaction solution was added to aqueous 10% KOH solution and precipitates formed. The mixture was decanted, and decantation was repeated for another 3 times with hot water. Methanol was added and the precipitates were collected by filtration, followed by washing the precipitates with methanol (74 g).

A mixture of 15 g of the generated 9,9'-di(4-aminophenyl)-2,7-dinitrofluorene, 50 g of NMP and 30 g of toluene was heated at 140°C to dissolve the solute, and Pd/C was added thereto. A mixed solution of 6.8 g of hydrazone monohydrate and 10 g of toluene was slowly dropped (2 hours) to the mixture under stirring and the mixture was filtered (to remove Pd/C). Propanol and water were added to the mixture to form precipitates, and the precipitates were filtered and washed with propanol (6.4 g).

E) Bis(3,5-diaminobenzoyl)-1,4-diaminobenzene

In 150 g of NMP, 5.5 g of aniline was dissolved, and 25 g of 3,5-dinitrobenzoyl chloride was slowly added thereto, followed by well stirring the resulting mixture. A mixture of 10 g of pyridine and 20 g of toluene was slowly added thereto. Under nitrogen, the mixture was heated at 150°C under stirring at 180 rpm for 100 minutes. Since crystals started to form when the mixture was left to stand, 45 g of methanol was added and the mixture was vigorously agitated, followed by leaving the resulting mixture to stand overnight. The precipitated crystals were filtered and washed with methanol to obtain 33 g of the crystals. The thus obtained dinitro compound was reduced with hydrazine in NMP in the presence of active carbon/palladium, to obtain the desired product.

Example 10

To a three-necked flask, 2.34 g of bis(3,5-diaminobenzoyl)4,4'-diaminodiphenyl ether (molecular weight: 468.46), 5.89 g of BPDA, 4 g of m-DADE, 0.2 g of oxalic anhydride, 0.8 g of pyridine, 80.g of NMP and 30 g of toluene were added. The mixture was allowed to react at 180°C, 180 rpm for 60 minutes, and then air-cooled. Then 6.20 g of ODPA, 2.93 g of mTPE, 53 g of NMP and 10 g of toluene were added, and the resulting mixture was allowed to react at 180°C, 180 rpm for 6 hours and 10 minutes. The obtained compound was in the form of gel. Molecular weight was measured by GPC. M=11,100, Mn=12,900, Mw=55,100, Mz=209,100, Mw/Mn=4.27.

Example 11

5.13 g of bis(3,5-diamino-phenyl)-2,2'-oxazol-diphenyl sulfone, 11.77 g of BPDA, 8.0 g of m-DADE, 0.8 g of valerolactone, 1.6 g of pyridine, 200 g of NMP and 30 g of toluene were added, and the mixture was allowed to react at 180°C, 180 rpm under nitrogen for 60 minutes. After air-cooling the mixture, 12.41 g of ODPA, 5.85 g of mTPE, 163 g of NMP and 20 g of toluene were added thereto, and the resulting mixture was allowed to react at 180°C for 6 hours and 20 minutes. Molecular weight was measured by GPC. M=16,200, Mn=13,200, Mw=44,700, Mz=157,300, Mw/Mn=3.37, Mz/Mn=11.96.

Example 12

To a three-necked flask, 5.13 g of bis(3,5-diaminophenyl)-2,2'-oxazol-4,4'-diphenylsulfone, 11.77 g of BPDA, 8.0 g of m-DADE, 0.8 g of valerolactone, 1.6 g of pyridine, 200 g of NMP and 30 g of toluene were added, and the mixture was allowed to react at 180°C, 180 rpm for 90 minutes. After air-cooling the mixture, 12.41 g of ODPA, 17.0 g of diaminosiloxane (above-described structural formula (8), amine number: 425), 91 g of NMP and 50 g of toluene were added, and the mixture was allowed to react at 180°C, 180 rpm for 6 hours to obtain a gelatinous compound. M=12,000, Mn=9,800, Mw=17,700, Mz=33,200, Mw/Mn=1.81.

Example 13

To a three-necked flask, 2.06 g of 2,7-diamino-9,9'-bis(4-aminophenyl)-fluorene, 5.89 g of BPDA, 4.0 g of m-DADE, 0.2 g of oxalic anhydride, 0.8 g of pyridine, 80 g of NMP and 30 g of toluene were added, and the mixture was

allowed to react at 180°C, 180 rpm for 60 minutes. After air-cooling the mixture, 6.20 g of ODPA, 2.93 g of mTPE, 40 g of NMP and 20 g of toluene were added, and the resulting mixture was allowed to react at 180°C, 180 rpm for 16 hours. M=23,700, Mn=14,300, Mw=28,900, Mz=52,700, Mw/Mn=2.03.

Synthesis Example Synthesis of BDP

To a three-necked separable flask made of glass equipped with a stainless steel anchor agitator and reflux condenser, a condenser comprising a trap and a cooling tube having balls and mounted on the trap was attached. The flask was heated by immersing the flask in a silicone oil bath under stirring under nitrogen gas flow at 500 ml/min. To the 2L-three necked glass vessel, 134 g (0.881 mol) of 3,5-diaminobenzoic acid (molecular weight: 152.15), 34.4 g (0.40 mol) of piperazine (molecular weight: 86.14), 410 g of N-methylpyrrolidone (hereinafter referred to as "NMP") and 40 g of toluene were added, and the mixture was stirred under nitrogen flow. Immersing the vessel in a silicone oil bath, the mixture was heated at 160°C under stirring at 170 rpm for 3 hours and 30 minutes. Then 100 g ofNMP was added and the resulting mixture was left to stand overnight, thereby precipitating crystals. The crystals were suction-filtered, washed with ethanol and dried.
Yield: 137 g (Mw 364.4) (94%), m.p.: 125-130°C. The NMR spectrum is shown in Fig. 1.

Example 14

The vessel described in Synthesis Example was used.
To a 500 ml three-necked flask, 3.64 g (10 mmol) of BDP (molecular weight: 364.39), 8.73 g (40 mmol) of pyromellitic dianhydride (molecular weight: 218.13), 4.88 g (40 mmol) of 2,4-diaminotoluene (molecular weight: 122,17), 0.8 g (8 mmol) of γ-valerolactone (molecular weight: 100.12) and 1.6 g (20 mmol) of pyridine (molecular weight: 79.10), 150 g of NMP and 30 g of toluene were added, and the mixture was stirring under $N_2$ flow. Immersing the flask in a silicone bath, the mixture was heated at 175°C under stirring at 170 rpm for 90 minutes. After air-cooling the mixture for 30 minutes, 12.89 g (40 mmol) of 3,4,3',4'-benzophenone tetracarboxylic dianhydride (hereinafter referred to as "BTDA") (molecular weight: 322.13), 8.65 g (20 mmol) of bis-(3-aminophenoxy)-4-phenyl)sulfone (molecular weight: 432.5), 173 g of NMP and 30 g of toluene were added thereto, and the mixture was allowed to react under heat and stirring.
While immersing the flask in the silicone bath such that 1/2 of the mixture was immersed in the silicone, the mixture was heated at 170°C, 175 rpm for 25 minutes and the mixture became a uniform solution. Then the reaction solution was well immersed in the silicone bath, and heated at 170°C under stirring at 180 rpm for 8 hours and 55 minutes. During the reaction, water was distilled together with toluene and accumulated in the trap. Two hours after the start of the reaction, the toluene-water fraction of distillate was removed and the heating was continued. An aliquot of the reaction solution was taken on a glass plate and was dried in a drier at 90°C for 30 minutes to generate a strong polyimide film. A 10% polyimide solution in NMP was generated, and the solution was gelled after leaving to stand overnight.
An aliquot of this solution was dissolved in dimethylformamide, and the molecular weight and its distribution were measured by high performance liquid chromatography (produced by TOSOH). Molecular weight based on polystyrene were as follows: Most frequent molecular weight (M): 25,600, number average molecular weight (Mn): 5,600, weight average molecular weight (Mw): 155,300, Z average molecular weight (Mz): 765,600, Mw/Mn: 27.8, Mz/Mn: 137. The molecular weight distribution measured by GPC is shown in Fig. 3. Thermal analysis was carried out using a thermal analysis apparatus TGA-50 produced by SHIMADZU CORPORATION. 5%- and 10%-decomposition temperatures were 430°C and 517°C, respectively, and the percent residue at 600°C was 76%. The results of the thermal analysis is shown in Fig. 5.

Example 15

Synthesis was carried out by operations similar to Example 14.
3.64 g (10 mmol) of BDP (molecular weight: 364.39), 11.70 g (40 mmol) of 3,4,3',4'-biphenyl tetracarboxylic dianhydride (hereinafter referred to as "BPDA"), 4.88 g (40 mmol) of 3,5-diaminotoluene, 0.8 g (8 mmol) of valerolactone, 1.6 g (20 mmol) of pyridine, 150 g of NMP and 30 g of toluene were added, and the mixture was stirred under $N_2$. Immersing the flask in a silicone bath, the mixture was allowed to react at 180°C, 170 rpm for 90 minutes to generate an oligomer. After air-cooling the mixture for 30 minutes, 3.64 g (40 mmol) of bis(dicarboxyphenyl)ether anhydride (referred to as "ODPA") (molecular weight: 312.22), 5.85 g (20 mmol) of bis-3-aminophenoxy-1,4-benzene (referred to as "mTPE") (molecular weight: 292.3), 52 g of NMP and 20 g of toluene were added while gently stirring (130 rpm) the mixture and gels precipitated. To the mixture, 100 g ofNMP was added, and the resulting mixture was heated at 175°C under stirring at 130 rpm and the mixture became a solution. The mixture was heated at 170°C under stirring at 175 rpm for 5 hours and 25 minutes. From 2 hours after the start of the reaction, the azeotropic distillate of toluene-water was

removed from the system. An aliquot of the solution was taken on a glass plate and flown, followed by heating the solution at 90°C for 30 minutes to obtain a strong film. After leaving the solution to stand overnight, the reaction solution gelled. A polyimide solution with a concentration of 9.5% was generated,

The molecular weight and its distribution were measured by GPC, and the results are shown in Fig. 4. Most frequent molecular weight (M): 32,800, number average molecular weight (Mn): 9,000, weight average molecular weight (Mw): 50,800, Z average molecular weight (Mz): 135,600, Mw/Mn=5.61, Mz/Mn=15.1. According to the measurement by thermal analysis, 5%- and 10%-decomposition temperatures were 401°C and 509°C, respectively, and the percent residue at 600°C was 75%. The infrared absorption spectrum, is shown in Fig. 2.

Example 16

Operations similar to Example 14 were repeated.

3,64 g (10 mmol) of BDP, 11.76 g (40 mmol) of BPDA, 15.38 g (40 mmol) of 9,9-bis(4-aminophenyl)fluorene (referred to as "FDA") (molecular weight: 348.5), 0.8 g of valerolactone, 1.6 g of pyridine, 200 g of NMP and 30 g of toluene were added, and the mixture was heated at 180°C under stirring at 180 rpm under nitrogen flow for 60 minutes. The mixture was then stirred at room temperature for 3 hours, and then 12.40 g (40 mmol) of ODPA (molecular weight: 310.22), 5.61 g (20 mmol) of bis(3-amino-4-hydroxyphenyl)sulfone (molecular weight: 280.27), 214 g of NMP and 50 g of toluene were added at room temperature. While immersing the flask in the silicone bath such that 1/2 of the mixture was immersed in the silicone bath, the mixture was heated at 180°C, 130 rpm for 15 minutes, and the mixture became a uniform solution. The mixture was then heated at 180°C under stirring at 180 rpm for 24 hours and 20 minutes. An aliquot of the solution was taken on a glass plate and flown, followed by heating the solution at 90°C for 30 minutes to obtain a strong film. The solution was a polyimide solution with a concentration of 10%. After leaving the solution to stand overnight, the reaction solution gelled.

The molecular weight and its distribution were measured by GPC. Most frequent molecular weight (M): 20,400, number average molecular weight (Mn): 5,600, weight average molecular weight (Mw): 19,600, Z average molecular weight (Mz): 38,500, Mw/Mn=3.50, Mz/Mn=6.87.

Thermal analysis was carried out. The 5%- and 10%-decomposition temperatures were 391°C and 483°C, respectively, and the percent residue at 600°C was 75%.

Example 17

Operations similar to Example 14 were repeated. To a three-necked separable flask made of glass equipped with a stainless steel anchor agitator, a condenser comprising a trap with a volume of 25 ml and a cooling tube having balls and mounted on the trap, was attached. The flask was heated by immersing the flask in a silicone oil bath under stirring under $N_2$ gas flow at 500 ml/min.

3.64 g of BDP, 11.77 g (40 mmol) of BPDA, 8.0 g (40 mmol) of diaminotoluene, 0.8 g of valerolactone, 1.6 g of pyridine, 150 g of NMP and 30 g of toluene were added, and the mixture was heated at 180°C under stirring at 175 rpm for 70 minutes. Toluene-water was azeotropically distillated and accumulated in the trap. After removing the accumulated distillate, the mixture was air-cooled, and 18.6 g (60 mmol) of ODPA (molecular weight: 310.23), 6.97 g (20 mmol) of FDA, 5.85 g (20 mmol) of mTPE, 52 g of NMP and 20 g of toluene were added under sterring at 130 rpm. Since gels were precipitated, the mixture was heated at 180°C, 120 rpm for 20 minutes while immersing 1/2 of the mixture and the mixture became a uniform solution. The mixture was then allowed to react at 180°C, 175 rpm for 9 hours and 5 minutes. The mixture formed a strong film. The mixture was a polyimide solution having a concentration of 10%. After leaving the mixture to stand overnight, the mixture gelled.

The molecular weight and its distribution were measured by GPC. Most frequent molecular weight (M): 26,800, number average molecular weight (Mn): 5,900, weight average molecular weight (Mw): 114,700, Z average molecular weight (Mz): 604,000, Mw/Mn=19.6, Mz/Mn=103. Thermal analysis was carried out. The 5%- and 10%-decomposition temperatures were 350°C and 492°C, respectively, and the percent residue at 600°C was 72%.

Example 18

Operations similar to Example 17 were repeated.

23.54 g (80 mmol) of BPDA, 4.88 g (40 mmol) of diaminotoluene, 0.8 g of valerolactone, 1.6 g of pyridine, 200 g of NMP and 30 g of toluene were added, and the mixture was heated at 180°C, 170 rpm for 60 minutes to generate an imide oligomer. After air-cooling the mixture, the mixture was stirred, and 3.64 g (10 mmol) ofBDP and 50 g of NMP were added. To the resulting mixture, 6.21 g (20 mmol) of bis(dicarboxyphenyl) ether dianhydride (hereinafter referred to as "ODPA"), 11.7 g (40 mmol) of mTPE, 100 g of NMP and 30 g of toluene were added, and the mixture was heated at 170°C under stirring at 175 rpm for 5 hours and 40 minutes. An aliquot of the solution was taken and tested, and a

strong film was formed. The mixture was a polyimide solution with a concentration of 10%. After leaving the solution to stand overnight, the solution gelled.

The molecular weight and its distribution were measured by GPC. Most frequent molecular weight (M): 24,800, number average molecular weight (Mn): 12,200, weight average molecular weight (Mw): 24,400, Z average molecular weight (Mz): 39,600, Mw/Mn=2.00, Mz/Mn=3.25. Thermal analysis was carried out using TGA-50. The 5%- and 10%-decomposition temperatures were 407°C and 525°C, respectively, and the percent residue at 600°C was 78%.

Example 19

Operations similar to Example 17 were repeated.

7.28 g (20 mmol) of BDP, 23.54 g (80 mmol) of BPDA, 16.0 g (80 mmol) of 3,4'-diaminodiphenyl ether (molecular weight: 200.2), 0.9 g (10 mmol) of oxalic anhydride (molecular weight: 90.04), 3.2 g (40 mmol) of pyridine (molecular weight: 79.10), 300 g of NMP and 50 g of toluene were added (since oxalic acid was hard to be dissolved, pyridine and NMP were added and the mixture was heated to dissolve it). The mixture was heated at 180°C under stirring at 175 rpm for 6 hours to generate a polyimide oligomer. After air-cooling the mixture for 1 hour, 24.82 g (40 mmol) of ODPA, 11.70 g (20 mmol) of mTPE, 354 g of NMP and 30 g of toluene were added, and the resulting mixture was heated at 180°C under stirring at 180 rpm for 6 hours to obtain a polyimide solution with a concentration of 10%. An aliquot of the solution was taken and tested, and a strong film was formed. After leaving the solution to stand overnight, the solution gelled.

Molecular weight was measurement by GPC. Most frequent molecular weight (M): 33,500, number average molecular weight (Mn): 12,500, weight average molecular weight (Mw): 118,500, Z average molecular weight (Mz): 486,900, Mw/Mn=9.47, Mz/Mn=38.9. According to thermal analysis, 5%-dccomposition temperature was 332°C.

Example 20

Operations similar to Example 17 were repeated.

3.64 g (10 mmol) of BDP,11.77 g (40 mmol) of BPDA, 8.0 g (40 mmol) of m-DADE, 0.8 g of valerolactone, 1.6 g of pyridine, 150 g of NMP and 30 g of toluene were added, and the mixture was heated at 180°C under stirring at 165 rpm for 6 hours. After air-cooling the mixture for 60 hours, 17.0 g (20 mmol) of diaminosiloxane (produced by SHIN-ETSU CHEMICAL, amine number: 425) and 60 g of toluene were added and the mixture was stirred. Then 12.41 g (40 mmol) of ODPA and 133 g of NMP were added and the mixture was stirred. Since the mixture came to be gelled, the mixture was heated at 180°C, 70 rpm for 20 minutes to make it a solution. The mixture was allowed to react at 180°C, 165 rpm for 6 hours and 45 minutes. An aliquot of the solution was taken and tested, and a film was formed. On the glass plate, the solution was heated at 90°C for 1 hour, and the film was peeled off from the glass plate. The film was mounted on a steel frame with pins and dried at 180°C for 2 hours. The film was then further dried at 220°C for 2 hours to obtain a strong film. (When the solution was heated at 180°C on the glass plate, the polyimide film was not be able to be peeled off. The film heated at 180°C did not pass the PCT test, but the film heated at 220°C for 2 hours kept the form of film in the PCT test (120°C, 24 hour) and passed the PCT test.

The molecular weight and its distribution were measured by GPC. Most frequent molecular weight (M): 13,200, number average molecular weight (Mn): 8,150, weight average molecular weight (Mw): 22,600, Z average molecular weight (Mz): 31,700, Mw/Mn=1.55, Mz/Mn=1.79. According to thermal analysis, the 5%-and 10%-decomposition temperatures were 461°C and 482°C, respectively, and the percent residue at 600°C was 76%.

Reference Example 1 Synthesis of Linear Polyimide

Operations similar to Example 17 were repeated.

41.19 g (140 mmol) of BPDA, 73.1 g (210 mmol) of FDA, 3-5 g (35 mmol) of valerolactone, 6.3 g (79 mmol) of pyridine, 400 g of NMP and 53 g of toluene were added, and the mixture was allowed to react at 180°C, 170 rpm for 60 hours to form an imide oligomer. After air-cooling the mixture, 41.19 g (140 mmol) of BPDA, 19.62 g (70 mmol) of bis (3-amino-4-hydroxyphenyl)sulfone (molecular weight: 280.27), 336 g of NMP and 20 g of toluene were added, and the resulting mixture was heated and stirred in an oil bath to make the mixture a solution. The solution was allowed to react at 180°C, 170 rpm for 4 hours and 10 minutes to obtain a polyimide solution with a concentration of 17%. Even after leaving the solution to stand overnight, the polyimide kept the form of solution.

Molecular weight was measurement by GPC. Most frequent molecular weight (M): 43,400, number average molecular weight (Mn): 21,200, weight average molecular weight (Mw): 47,800, Z average molecular weight (Mz): 82,600, Mw/Mn=2.25, Mz/Mn=3.89.

Reference Example 2 Synthesis of Linear Polyimide

62.044 g (200 mmol) of ODPA, 12.22 g (100 mmol) of diaminotoluene, 3 g of valerolactone, 4.8 g of pyridine, 300 g of NMP and 50 g of toluene were added, and the mixture was allowed to react at 180°C, 165 rpm for 60 minutes to form an imide oligomer. After air-cooling the mixture, 29.42 g (100 mmol) of BPDA, 69.60 g (200 mmol) of FDA, 550 g of NMP and 50 g of toluene were added, and the resulting mixture was allowed to react at 175°C under stirring at 170 rpm for 4 hours and 20 minutes. After the reaction, 70 g of NMP was added to obtain a polyimide solution with a concentration of 15%. The molecular weight and its distribution were measured by GPC. Most frequent molecular weight (M): 71,900, number average molecular weight (Mn): 28,400, weight average molecular weight (Mw): 75,800, Z average molecular weight (Mz): 132,300, Mw/Mn=2.66, Mz/Mn=4.65. As a result of the thermal analysis, the 5%- and 10%-decomposition temperatures were 518°C and 552°C, respectively, and the percent residue at 600°C was almost zero. The results of TG-GTA are shown in Fig. 6.

Example 21 Mixed Polymerization

In 210 g (polyimide content of 35.7 g) of the linear polyimide solution obtained in Reference Example 1, the reaction of Example 15 was carried out. That is, 3.64 g of BDP, 4,88 g of diaminotoluene, 11.77 g of BPDA, 0.45 g (5 mmol) of oxalic acid, 1.6 g (20 mmol) of pyridine, 150 g of NMP and 30 g of toluene were added, and the resulting mixture was allowed to react at 180°C, 180 rpm for 60 hours, followed by leaving the mixture to stand at room temperature for 30 minutes. Then 12.41 g of ODPA, 5.85 g of mTPE, 150 g ofNMP and 20 g of toluene were added, and the resulting mixture was allowed to react at 180°C, 175 rpm for 4 hours and 25 minutes. The resulting mixture was in the form of a uniform solution, and it remained as a stable solution at room temperature even being left to stand overnight

The molecular weight and its distribution were measured by GPC. Most frequent molecular weight (M): 97,400, number average molecular weight (Mn): 13,000, weight average molecular weight (Mw): 65,300, Z average molecular weight (Mz): 151,100, Mw/Mn=5.0, Mz/Mn=11.6. As a result of the measurement by TG-GTA, the 5%- and 10%-decomposition temperatures were 465°C and 548°C, respectively, and the percent residue at 600°C was 86%.

Example 22 Mixed Polymerization

In 175 g (polyimide content of 30 g) of the polyimide solution obtained in Example 15, the reaction of Reference Example 1 was carried out. That is, to the 10% polyimide solution of Example 15, 8.23 g of BPDA, 14.63 g of FDA, 0.45 g of oxalic acid, 1.6 g of pyridine, 150 g of NMP and 40 g of toluene were added. The resulting mixture was slowly stirred at 180°C, 130 rpm and it became a solution in about 10 minutes. The mixture was allowed to react at 180°C, 155 rpm for 60 hours. After air-cooling the mixture for 30 minutes, 8.23 g of BPDA, 3.92 g of bis (3-amino-4-hydroxyphenyl) sulfone, 150 g of NMP and 20 g of toluene were added, and the resulting mixture was allowed to react at 180°C, 170 rpm for 4 hours and 25 minutes. Even after leaving the reaction solution to stand overnight, it was a stable polyimide solution at room temperature.

The molecular weight and its distribution were measured by GPC. Most frequent molecular weight (M): 80,200, number average molecular weight (Mn): 27,800, weight average molecular weight (Mw): 96,400, Z average molecular weight (Mz): 195,700, Mw/Mn=3.47, Mz/Mn=7.05. As a result of the measurement by TG, the 5%- and 10%-decomposition temperatures were 424°C and 528°C, respectively, and the percent residue at 600°C was 83%.

Example 23 Mixed Polymerization

To 200 g (polyimide content of 20 g) of the 10% polyimide solution obtained in Example 19, 2.28 g of BDP, 5.46 g of pyromellitic dianhydride, 3.65 g of diaminotoluene, 0.5 g of oxalic acid, 1.0 g of pyridine, 94 g of NMP and 40 g of toluene were added, and the mixture was heated to 180°C to dissolve it, followed by allowing the mixture to react at 180°C, 175 rpm for 75 minutes. After air-cooling the mixture at room temperature for 30 minutes, 7.36 g of BPDA, 3.65 g of mTPE, 86 g of NMP and 20 g of toluene were added, and the resulting mixture was allowed to react at 180°C, 160 rpm for 6 hours and 45 minutes. After leaving the mixture to stand overnight, it gelled. A polyimide film was obtained from this solution.

The molecular weight and its distribution were measured by GPC. Most frequent molecular weight (M): 30,900, number average molecular weight (Mn): 11,600, weight average molecular weight (Mw): 74,700, Z average molecular weight (Mz): 223,100, Mw/Mn=6.43, Mz/Mn=19.2.

Reference Example 3 Mixed Reaction

In 200 g (polyimide content of 30 g) of the 15% polyimide solution obtained in Reference Example 1, the

imidation reaction described in Reference Example 2 was carried out. This was the mixed reaction of linear polyimides. That is, to 200 g of the polyimide obtained in Reference Example 1,11.48 g of ODPA, 2.26 g of diaminotoluene, 0.4 g of oxalic acid, 0,8 g of pyridine, 56 g of NMP and 40 g of toluene were added, and the resulting mixture was allowed to react at 180°C, 170 rpm for 70 minutes. After air-cooling the mixture for 30 minutes, 5.44 g of BPDA, 12.88 g of FDA, 65 g of NMP and 20 g of toluene were added, and the resulting mixture was allowed to react at 180°C, 160 rpm for 5 hours and 30 minutes. A strong polyimide film was obtained. After leaving the mixture to stand at room temperature, the mixture was a stable polyimide solution.

The molecular weight and its distribution were measured by GPC. Most frequent molecular weight (M): 63,500, number average molecular weight (Mn): 19,100, weight average molecular weight (Mw): 62,000, Z average molecular weight (Mz): 110,700, Mw/Mn=3.25, Mz/Mn=5.80. Thermal analysis was carried out. The 5%- and 10%-decomposition temperatures were 440°C and 550°C, respectively, and the percent residue at 600°C was 85%.

Example 24 Mixed Reaction

In 140 g (polyimide content of 14 g) of 10% polyimide obtained in Example 16, the imidation reaction described in Reference Example 2 was carried out. That is, 7.63 g of ODPA, 1.50 g of diaminotoluene, 0.45 g of oxalic acid, 1.6 g of pyridine, 100 g of NMP and 40 g of toluene were added, and the resulting mixture was allowed to react at 180°C, 165 rpm for 60 minutes. After allowing the mixture to cool to room temperature, 3.62 g of BPDA, 8.56 g of FDA, 100 g of NMP and 30 g of toluene were added, and the resulting mixture was allowed to react at 180°C, 165 rpm for 6 hours and 45 minutes. After leaving the reaction mixture to stand overnight, it gelled.

The molecular weight and its distribution were measured. Most frequent molecular weight (M): 27,600, number average molecular weight (Mn): 13,300, weight average molecular weight (Mw): 53,100, Z average molecular weight (Mz): 143,300, Mw/Mn=3.47, Mz/Mn=9.35. Thermal analysis was carried out. The 5%- and 10%-decomposition temperatures were 418°C and 545°C, respectively.

Example 25 Mixed Reaction

In 100 g (polyimide content of 15 g) of 15% polyimide containing diaminosilane obtained in Example 20, the reaction described in Reference Example 2 was carried out. That is, 6.02 g ODPA, 1.22 g of diaminotoluene, 0.4 g of valerolactone, 0.8 g of pyridine, 30 g of NMP and 30 g of toluene were added, and the mixture was allowed to react at 180°C, 170 rpm for 60 minutes. After air-cooling the mixture for 60 minutes, 2.94 g of BPDA, 6.96 g of FDA, 35 g of NMP and 30 g of toluene were added, and the resulting solution was heated for 10 minutes such that half of the mixture was immersed in the bath to obtain a uniform solution. The mixture was allowed to react at 180°C, 165 rpm for 4 hours and 25 minutes. Even after leaving the mixture to stand overnight, the mixture was a stable uniform solution, and a strong polyimide film was formed.

The molecular weight and its distribution were measured by GPC. Most frequent molecular weight (M); 25,900, number average molecular weight (Mn): 14,000, weight average molecular weight (Mw): 28,700, Z average molecular weight (Mz): 68,600, Mw/Mn=2.06, Mz/Mn=4.92. Thermal analysis was carried out. The 5%- and 10%-decomposition temperatures were 445°C and 501°C, respectively, and the percent residue at 600°C was 82%.

Example 26

In 100 g (polyimide content of 15 g) of 15% polyimide solution obtained in Reference Example 2, the reaction described in Example 20 was carried out. That is, 1.21 g of BDP, 3.92 g of BPDA, 2.67 g of m-DADE, 0.4 g of valerolactone, 0.8 g of pyridine, 50 g of NMP and 30 g of toluene were added, and the mixture was heated at 180°C, 100 rpm for 10 minutes, followed by allowing the mixture to react at 180°C , 170 rpm for 60 minutes. After air-cooling the mixture for 10 minutes, 5.7 g of silicone diamine (amine number: 425) and 30 g of toluene were added, and then 4.14 g of ODPA and 50 g of NMP were added. The resulting solution was heated for 10 minutes under stirring at 160 rpm such that half of the mixture was immersed in the bath to obtain a uniform solution. The mixture was allowed to react at 180°C, 160 rpm for 4 hours and 25 minutes. Even after leaving the mixture to stand overnight, the mixture was a stable uniform solution.

The molecular weight and its distribution were measured by GPC. Most frequent molecular weight (M): 33,300, number average molecular weight (Mn): 17,700, weight average molecular weight (Mw): 52,100, Z average molecular weight (Mz): 114,100, Mw/Mn=2.94, Mz/Mn=6.44. According to thermal analysis, the 5%- and 10%-decomposition temperatures were 450°C and 487°C, respectively, and the percent residue at 600°C was 76%.

Example 27

To compare with the mixed reaction system of the 2 types of polyimides described in Examples 22 to 26, equal

amounts of the 2 types of polyimides were mixed by stirring, respectively. They were in the form of stable solution at room temperature. Weight average molecular weight (Mw), distribution (Mw/Mn) and results of thermal analysis are shown in Table 2 in comparison.

Table 2

| Stir-Mixed System | | Mixed Reaction System | | | | |
|---|---|---|---|---|---|---|
| Mw<br>Mw/Mn | Mixed System* | Example | Mw<br>Mw/Mn | Thermal Analysis | | |
| | | | | 5%-decom. °C | 10%-decom. °C | % residue at 600°C |
| — | | 21 | 65,300<br>5.0 | 465 | 548 | 86 |
| 70,200<br>2.26 | Example 15+ Reference Example 1 | 22 | 96,400<br>3.47 | 424 | 528 | 83 |
| 74,600<br>2.75 | Example 19 | 23 | 74,700<br>6.43 | | | |
| 109,200<br>1.86 | Reference Example 1+ Reference Example 2 | Reference Example 3 | 62,000<br>3.25 | 440 | 550 | 85 |
| 46,600<br>2.11 | Example 16+ Reference Example 2 | 24 | 53,100<br>3.47 | 418 | 545 | |
| 35,900<br>1.92 | Example 20+ Reference Example 2 | 25 | 28,700<br>2.06 | 445 | 501 | 82 |
| — | | 26 | 52,100<br>2. 94 | 450 | 487 | 76 |
| 36,200<br>1.86 | Example 19+ Reference Example 2 | | | | | |
| *: Two types of polyimide solutions having the same content of polyimide were mixed by stirring. | | | | | | |

The characteristics of the polyimides prepared by mixed reaction are different from those of the polyimides prepared by mechanical mixing. Particularly, the molecular weight distributions Mw/Mn of the mixed reaction polyimides are large. In the PCT test of the polyimides, the polyimides dried at 180°C for 2 hours were decomposed at 120°C for 24 hours, but the polyimides dried at 220°C for 2 hours were stable at 120°C for 24 hours. By the mixing of the cross-linked polyimides, the degree of improvements of the polyimides is small. The polyimides prepared by canying out the cross-linking reaction in linear polyimide excel in film strength and the like. Characteristics of the mixed polyimides are also improved. The increase in the molecular weight by the reaction of a linear polyimide in a cross-linked polyimide is small.

Example 28 Experiment for Photosensitivity of Polyimide

To the polyimide solution (10%) obtained in Example 22, naphthoquinone diazide PC-5 in an amount of 20% based on the polyimide was added. A silicon wafer was coated with KBM-903 (aminosilane coupling agent produced by SHIN-ETSU CHEMICAL) by spin coating (1000 rpm for 20 seconds, and the 1500 rpm for 20 seconds). The resultant was baked at 90°C for 10 minutes. The polyimide solution containing the photosensitizer PC-5 was applied on the wafer by spin coating at 1000 rpm for 20 seconds and then at 5000 rpm for 20 seconds. The resulting polyimide film had a thickness of 1.88 μm. A test pattern of positive-type photomask was placed on the photosensitive coating film, and the film was irradiated with a 2kW extra-high pressure mercury lamp with an energy of 380 mJ. The coating film was developed

in $A_0$ developer (aminoethanol:NMP:water = 1:1:1) for 7 minutes, and washed with deionized water. The film was then dried at 90°C for 30 minutes and at 200°C for 30 minutes in an infrared dryer, and the resolution was observed. Formation of a sharp positive image of 3 μm line-and-space pattern was confirmed.

Example 29 Photosensitive Polyimide Test

To the polyimide obtained in Example 23, naphthoquinone diazide PC-5 was added in an amount of 20% based on the polyimide. On a silicon wafer, KBM-903 (aminosilane coupling agent produced by SHIN-ETSU CHEMICAL) by spin coating at 1500 rpm, and the resultant was baked at 90°C for 10 minutes. On the resultant, the polyimide solution was applied by spin coating at 1000 rpm for 20 seconds and then at 5500 rpm for 20 seconds, and the resultant was prebaked at 90°C for 10 minutes in an infrared dryer. The film thickness was 0.94 μm. On the film, a test pattern for positive-type photomask was placed, and the same operations as in Example 28 were repeated. The exposed film was immersed in the developer for 9 minutes, and 3 μm positive image was confirmed.

Example 30

To the mixed copolymerized polyimide solution obtained by the same process as in Example 21 except that 3,5-diaminobenzoic acid was used in place of diaminotoluene, a solution of γ-butyrolactone, cyclohexanone and anisole etc. was added, and N-methylmorpholine as a neutralizer was added, followed by diluting the resulting mixture with water to prepare an electrodeposition solution. In the electrodeposition solution, copper foil (positive electrode) to be coated and a stainless steel plate (negative electrode) were immersed, and electric current from a direct current source was passed between the electrodes, thereby carrying out an experiment for anion electrodeposition. After the electrodeposition, the copper foil was washed with aqueous N-methylpyrrolidone solution and then with water to carry out the fixing, and the resultant was dried at 90°C for 10 minutes and then at 200°C for 30 minutes in an infrared hot air dryer to obtain an electrodeposited polyimide film.

Example 31

<Formation of Photosensitive Polyimide Film by Electrodeposition Coating>

To the above-described polyimide solution, a photoacid generator, naphthoquinone diazide, was added to prepare an electrodeposition solution in the same manner as described above, By the electrodeposition experiment, polyimide film was deposited on the copper foil. After washing with water, the film was dried at 90°C for 10 minutes in an infrared hot air dryer. A mask was placed on this film and the film was irradiated with light with a high pressure Hg-Xe lamp, followed by developing with a developer containing aminoethanol. As a result, a positive image was formed.

## Claims

1. A process for producing a composition containing a cross-linked polyimide, comprising polycondensing one or more tetramines, one or more tetracarboxylic dianhydrides and one or more aromatic diamines in a polar solvent containing toluene or xylene in the presence of a catalyst under heat, whereby polyimide is formed directly.

2. The process according to claim 1, wherein the or each said tetramines is an aromatic tetramine.

3. The process according to claim 2, wherein said one or more aromatic tetramines are at least one selected from the group consisting of bis(3,5-diaminobenzoyl)-1,4-piperazine, bis(3,5-diaminobenzoyl)-4,4'-dieminodiphenylether, bis-(3,5-diaminophenyl)-2,2'-dioxazol-4,4'-diphenylsulfone, bis(3,5-diaminophenyl)-2,2'-dioxazol-4,4'-biphenyl, 2,7-diamino-9,9'-(bis-4-aminophenyl)fluorene and bis(3,5-diaminobenzoyl)-1,4-diaminobenzene.

4. The process according to any one of claims 1 to 3, wherein a diaminosiloxane is contained as a part of diamine component.

5. The process according to any one of claims 1 to 4, wherein said catalyst is a binary catalyst comprising one or more acids selected from oxalic acid, malonic acid, formic acid and pyruvic acid, and a base; or a binary catalyst comprising a lactone and a base.

6. The process according to claim 5, wherein said catalyst is a binary catalyst comprising oxalic acid and a base, or

a binary catalyst comprising a lactone and a base.

7. The process according to claim 6, wherein the reactants are directly imidized in the presence of said binary catalyst at 160°C to 200°C.

8. The process according to any one of claims 1 to 7 which proceeds by sequential reactions, comprising polycondensing a tetramine, a tetracarboxylic dianhydride and an aromatic diamine in the presence of the catalyst to generate a polyimide oligomer, and then reacting the polyimide oligomer, a tetracarboxylic dianhydride and an aromatic diamine.

9. The process according to claim 8, wherein the number of moles of said tetracarboxylic dianhydride and the number of moles of said aromatic diamine, which are reacted, are different, and the difference is 2 moles per 1 mole of said tetramine.

10. The process according to claim 9, wherein said tetramine, 4 moles of said tetracarboxylic dianhydride and 4 moles of said aromatic diamine are reacted per 1 mole of said tetramine to generate said polyimide oligomer, and then reacting the polyimide oligomer, 4 moles of the tetracarboxylic dianhydride and 2 moles of the aromatic diamine.

11. The process according to claim 9, wherein said tetramine, 8 moles of said tetracarboxylic dianhydride and 4 moles of said aromatic diamine are reacted per 1 mole of said tetramine to generate said polyimide oligomer, and then reacting the polyimide oligomer, 2 moles of the tetracarboxylic dianhydride and 4 moles of the aromatic diamine.

12. A process for producing a cross-linked polyimide composition, comprising adding one or more tetracarboxylic dianhydrides and one or more aromatic diamines to the polyimide composition produced by the process according to any one of claims 1 to 11, mixing the mixture and polycondensing them.

13. A process for producing a composition, comprising carrying out said process according to any one of claims 1 to 11 to produce a first composition containing a cross-linked polyimide; producing a second composition containing, a linear polyimide composition by carrying out the process according to claim 1 except that no tetramine is used; and mixing said first and second compositions.

**Patentansprüche**

1. Verfahren zur Herstellung einer Zusammensetzung, die ein vernetztes Polyimid enthält, umfassend das Polykondensieren eines oder mehrerer Tetramine, eines oder mehrerer Tetracarbonsäuredianhydride und eines oder mehrerer aromatischer Diamine in einem polaren Lösungsmittel, das Toluol oder Xylol enthält, in Gegenwart eines Katalysators unter Erhitzen, wodurch das Polyimid direkt gebildet wird.

2. Verfahren nach Anspruch 1, worin das bzw. jedes Tetramin ein aromatisches Tetramin ist.

3. Verfahren nach Anspruch 2, worin das eine oder die mehreren Tetramine zumindest ein aus der aus Bis(3,5-diaminobenzoyl)-1,4-piperazin, Bis(3,5-diaminophenyl)-2,2'-dioxazol-4,4'-diphenylsulfon, Bis(3,5-diaminophenyl)-2,2'-dioxazol-4,4'-biphenyl, 2,7-Diamino-9,9'-(bis-4-aminophenyl)fluorol und Bis(3,5-diaminobenzoyl)-1,4-diaminobenzol bestehenden Gruppe ausgewählten sind.

4. Verfahren nach einem der Ansprüche 2 und 3, worin ein Diaminosiloxan als Teil der Diaminkomponente enthalten ist.

5. Verfahren nach einem der Ansprüche 2 bis 4, worin der Katalysator ein binärer Katalysator, der eine oder mehrere aus Oxalsäure, Malonsäure, Ameisensäure und Brenztraubensäure ausgewählte Säuren und eine Base umfasst; oder ein binärer Katalysator, der ein Lacton und eine Base umfasst, ist.

6. Verfahren nach Anspruch 5, worin der Katalysator ein binärer Katalysator, der Oxalsäure und eine Base umfasst, oder ein binärer Katalysator, der ein Lacton und eine Base umfasst, ist.

7. Verfahren nach Anspruch 6, worin die Reaktionspartner in Gegenwart des binären Katalysators bei 160 °C bis 200 °C direkt imidisiert werden.

8. Verfahren nach einem der Ansprüche 1 bis 7, das mittels aufeinander folgender Reaktionen abläuft und das Polykondensieren eines Tetramins, eines Tetracarbonsäuredianhydrids und eines aromatischen Diamins in Gegenwart des Katalysators zur Bildung eines Polyimid-Oligomers und das anschließende Umsetzen des Polyimid-Oligomers, eines Tetracarbonsäuredianhydrids und eines aromatischen Diamins umfasst.

**9.** Verfahren nach Anspruch 8, worin die Molanzahl des Tetracarbonsäuredianhydrids und die Molanzahl des aromatischen Diamins, die miteinander umgesetzt werden, unterschiedlich sind und der Unterschied 2 mol pro 1 mol des Tetramins ausmacht.

**10.** Verfahren nach Anspruch 9, worin das Tetramin, 4 mol des Tetracarbonsäuredianhydrids und 4 mol des aromatischen Diamins pro 1 mol des Tetramins umgesetzt werden, um ein Polyimid-Oligomer zu bilden, und anschließend das Polyimid-Oligomer, 4 mol des Tetracarbonsäuredianhydrids und 2 mol des aromatischen Diamins miteinander umgesetzt werden.

**11.** Verfahren nach Anspruch 9, worin das Tetramin, 8 mol des Tetracarbonsäuredianhydrids und 4 mol des aromatischen Diamins pro 1 mol des Tetramins umgesetzt werden, um ein Polyimid-Oligomer zu bilden, und anschließend das Polyimid-Oligomer, 2 mol des Tetracarbonsäuredianhydrids und 4 mol des aromatischen Diamins miteinander umgesetzt werden.

**12.** Verfahren zur Herstellung einer vernetzten Polyimidzusammensetzung, umfassend das Hinzufügen eines oder mehrerer Tetracarbonsäuredianhydride und eines oder mehrerer aromatischer Diamine zu der durch ein Verfahren nach einem der Ansprüche 1 bis 11 hergestellten Polyimidzusammensetzung, das Durchmischen sowie das Polykondensieren des Gemischs.

**13.** Verfahren zur Herstellung einer Zusammensetzung, umfassend das Durchführen eines Verfahrens nach einem der Ansprüche 1 bis 11, um eine erste Zusammensetzung herzustellen, die ein vernetztes Polyimid enthält, das Herstellen einer zweiten Zusammensetzung, die eine lineare Polyimidzusammensetzung enthält, mittels Durchführung eines Verfahrens nach Anspruch 1 mit der Ausnahme, dass kein Tetramin verwendet wird, und das Vermischen der ersten und der zweiten Zusammensetzung.

## Revendications

**1.** Procédé de production d'une composition contenant un polyimide réticulé, comprenant la polycondensation d'une ou de plusieurs tétraamines, d'une ou de plusieurs dianhydrides tétracarboxyliques et d'une ou de plusieurs diamines aromatiques dans un solvant polaire contenant du toluène ou xylène en présence d'un catalyseur sous chaleur, par quoi le polyimide est formé directement.

**2.** Procédé selon la revendication 1, dans lequel la ou chaque tétramine précitée est une tétramine aromatique.

**3.** Procédé selon la revendication 2, dans lequel une ou plusieurs tétramines aromatiques précitées sont au moins une sélectionnée dans le groupe consistant en bis(3,5-diaminobenzoyl)-1,4-pipérazine, bis(3,5-diaminobenzoyl)-4,4'-diaminodiphényléther, bis-(3,5-diaminophényl)-2,2'-dioxazol-4,4'-diphénylsulfone, bis(3,5-diaminophényl)-2,2'-dioxazol-4,4'-biphényl, 2,7-diamino-9,9'-(bis-4-aminophényl)fluorène et bis(3,5-diaminobenzoyl)-1,4-diaminobenzène.

**4.** Procédé selon l'une quelconque des revendications 1 à 3, dans lequel une diaminosiloxane fait partie du contenu en tant que partie du composant de diamine.

**5.** Procédé selon l'une quelconque des revendications 1 à 4, dans lequel ledit catalyseur est un catalyseur binaire comprenant un ou plusieurs acides sélectionnés parmi l'acide oxalique, l'acide malonique, l'acide formique et l'acide pyruvique, et une base; ou un catalyseur binaire comprenant un lactone et une base.

**6.** Procédé selon la revendication 5, dans lequel ledit catalyseur est un catalyseur binaire comprenant de l'acide oxalique et une base, ou un catalyseur binaire comprenant un lactone et une base.

**7.** Procédé selon la revendication 6, dans lequel les réactifs sont directement imidisés en présence dudit catalyseur binaire à 160°C jusqu'à 200°C.

8. Procédé selon l'une quelconque des revendications 1 à 7, qui procède par réactions séquentielles, comprenant la polycondensation d'une tétramine, d'un dianhydride tétracarboxylique et d'une diamine aromatique en présence du catalyseur pour produire un oligomère de polyimide, et en faisant réagir ensuite l'oligomère de polyimide, le dianhydride tétracarboxylique et une diamine aromatique.

9. Procédé selon la revendication 8, dans lequel le nombre de moles dudit dianhydride tétracarboxylique et le nombre de moles de ladite diamine aromatique, qui sont amenés à réagir, sont différents, et la différence est de 2 moles par 1 mole de ladite tétramine.

10. Procédé selon la revendication 9, dans lequel ladite tétramine, 4 moles dudit dianhydride tétracarboxylique et 4 moles de ladite diamine aromatique sont amenés à réagir pour 1 mole de ladite tétramine pour produire ledit oligomère de polyimide, suivi de la réaction de l'oligomère de polyimide, de 4 moles du dianhydride tétracarboxylique et de 2 moles de la diamine aromatique.

11. Procédé selon la revendication 9, dans lequel ladite tétramine, 8 moles dudit dianhydride tétracarboxylique et 4 moles de ladite diamine aromatique sont amenés à réagir pour 1 mole de ladite tétramine pour produire ledit oligomère de polyimide, suivi de la réaction de l'oligomère de polyimide, de 2 moles dudit anhydride tétracarboxylique et de 4 moles de la diamine aromatique.

12. Procédé de production d'une composition de polyimide réticulée, comprenant l'ajout d'un ou de plusieurs dianhydrides tétracarboxyliques et d'un ou de plusieurs amines aromatiques à la composition de polyimide produite selon le procédé suivant l'une quelconque des revendications 1 à 11, le mélange du mélange et la polycondensation de ceux-ci.

13. Procédé de production d'une composition, comprenant l'exécution dudit procédé selon l'une quelconque des revendications 1 à 11 pour produire une première composition contenant un polyimide réticulé; produire une deuxième composition contenant une composition de polyimide linéaire en exécutant le procédé selon la revendication 1 excepté que la tétramine n'est pas utilisée; et mélanger lesdites première et deuxième compositions.

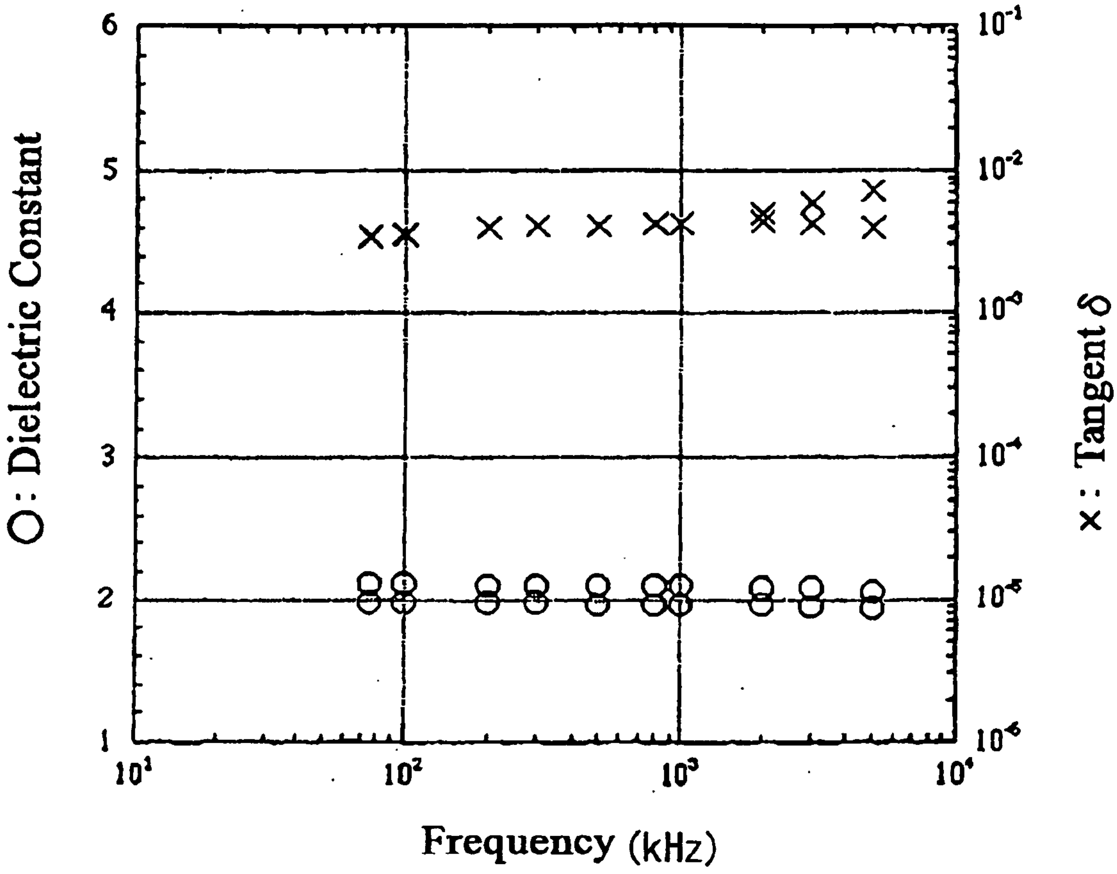
6
5
4
3
2
1
10⁻¹
10⁻²
10⁻³
10⁻⁴
10⁻⁵
10⁻⁶
10¹
10²
10³
10⁴
O : Dielectric Constant
x : Tangent δ
Frequency (kHz)

**Fig. 1**

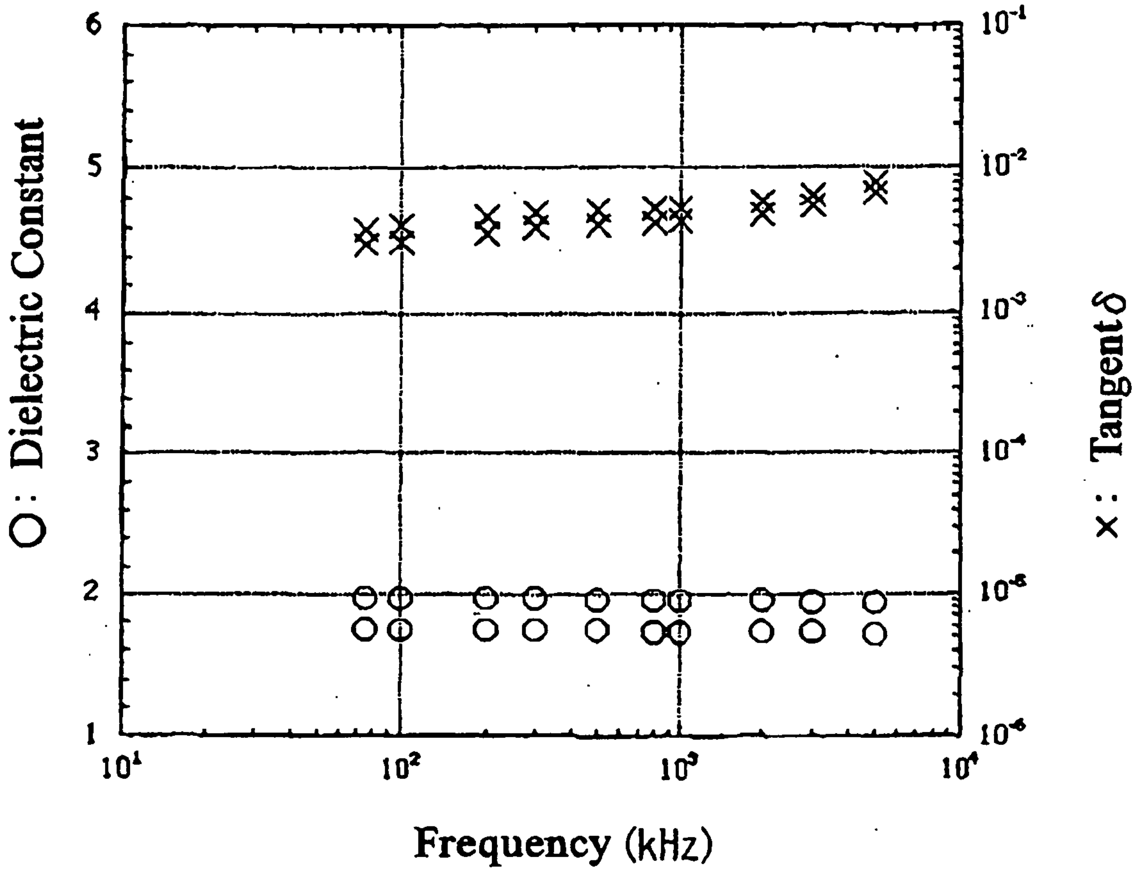
6
5
4
3
2
1
10^-1
10^-2
10^-3
10^-4
10^-5
10^-6
10^1
10^2
10^3
10^4
○ : Dielectric Constant
× : Tangent δ
Frequency (kHz)

Fig. 2

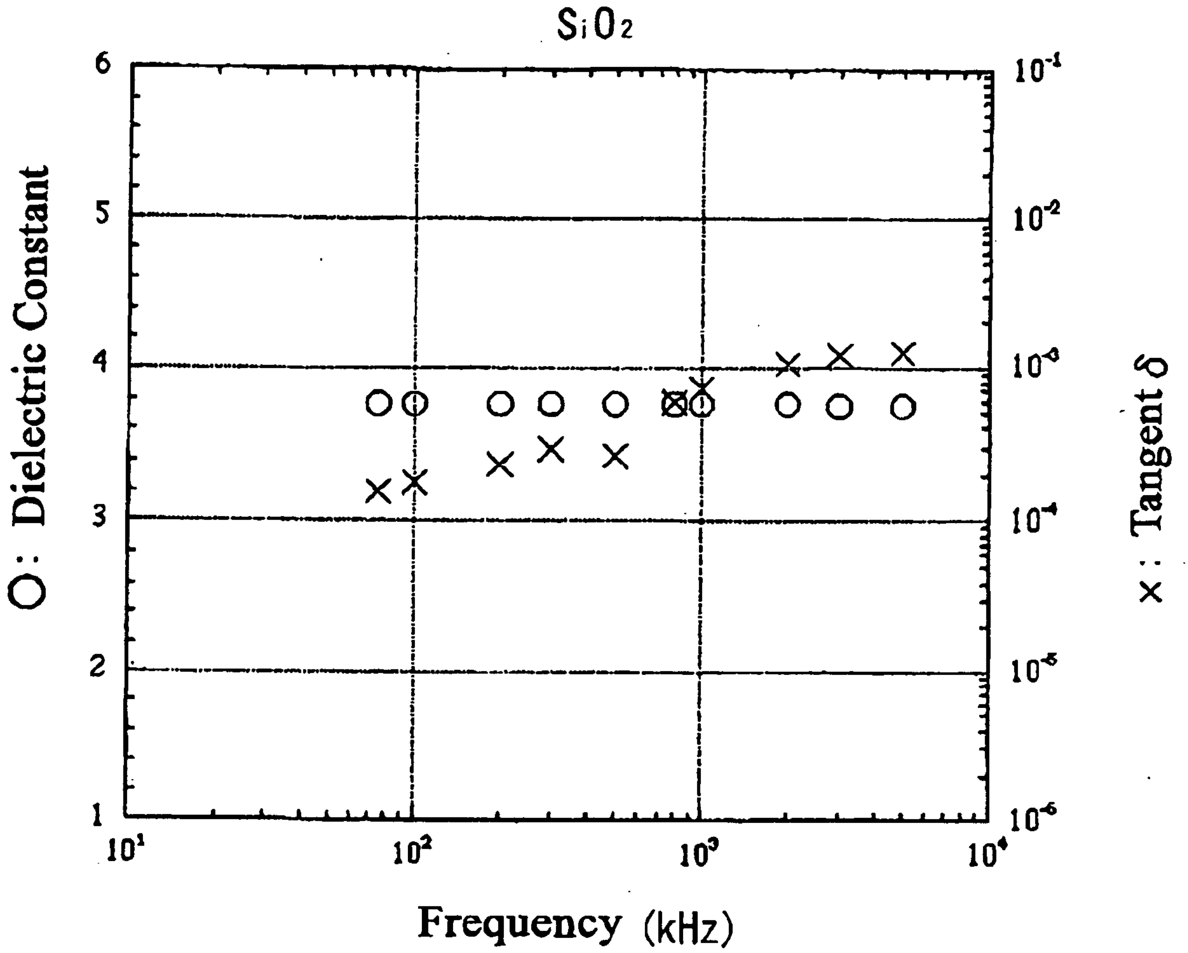
SiO2
6
5
4
3
2
1
10^1
10^2
10^3
10^4
10^-1
10^-2
10^-3
10^-4
10^-5
10^-6
○ : Dielectric Constant
× : Tangent δ
Frequency (kHz)

Fig. 3

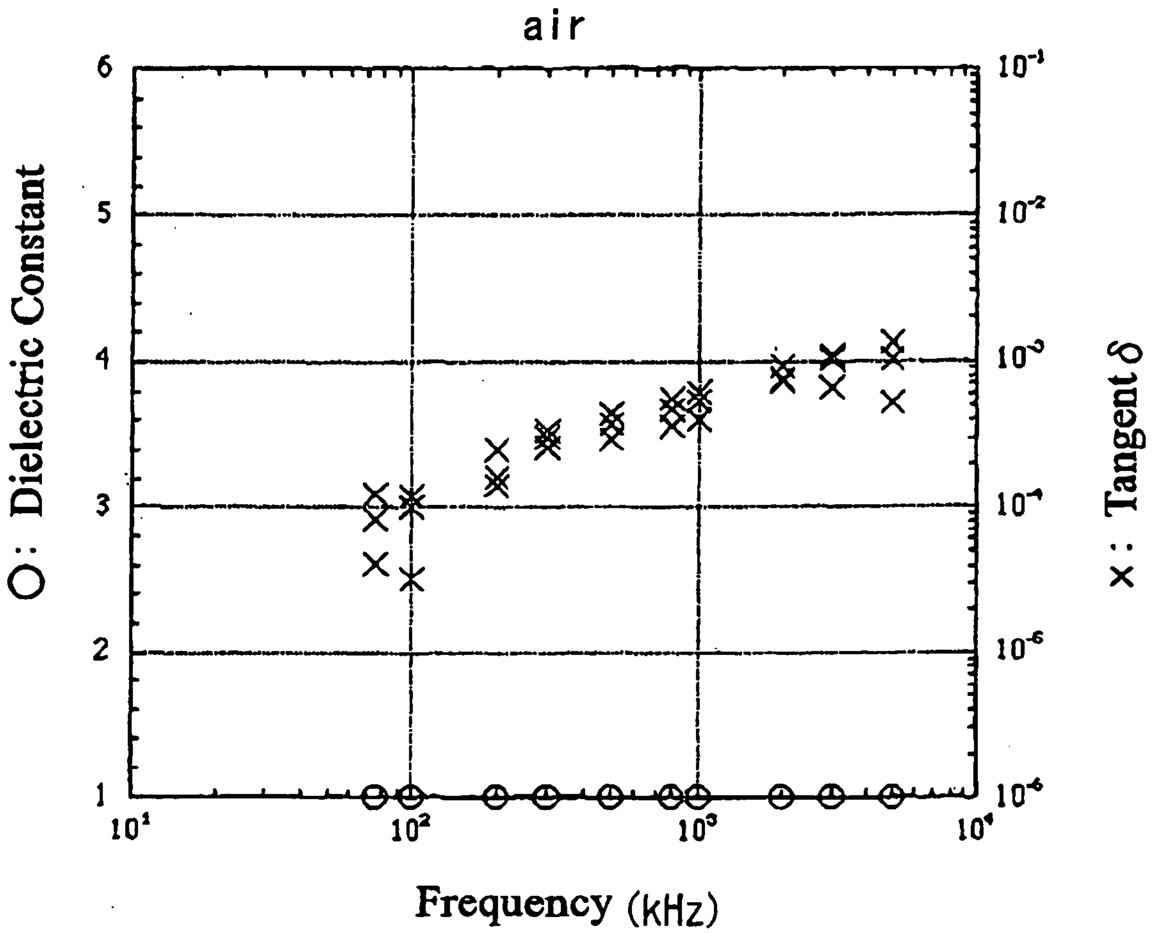
air
6
5
4
3
2
1
10⁻¹
10⁻²
10⁻³
10⁻⁴
10⁻⁵
10⁻⁶
10¹
10²
10³
10⁴
○ : Dielectric Constant
× : Tangent δ
Frequency (kHz)

**Fig. 4**

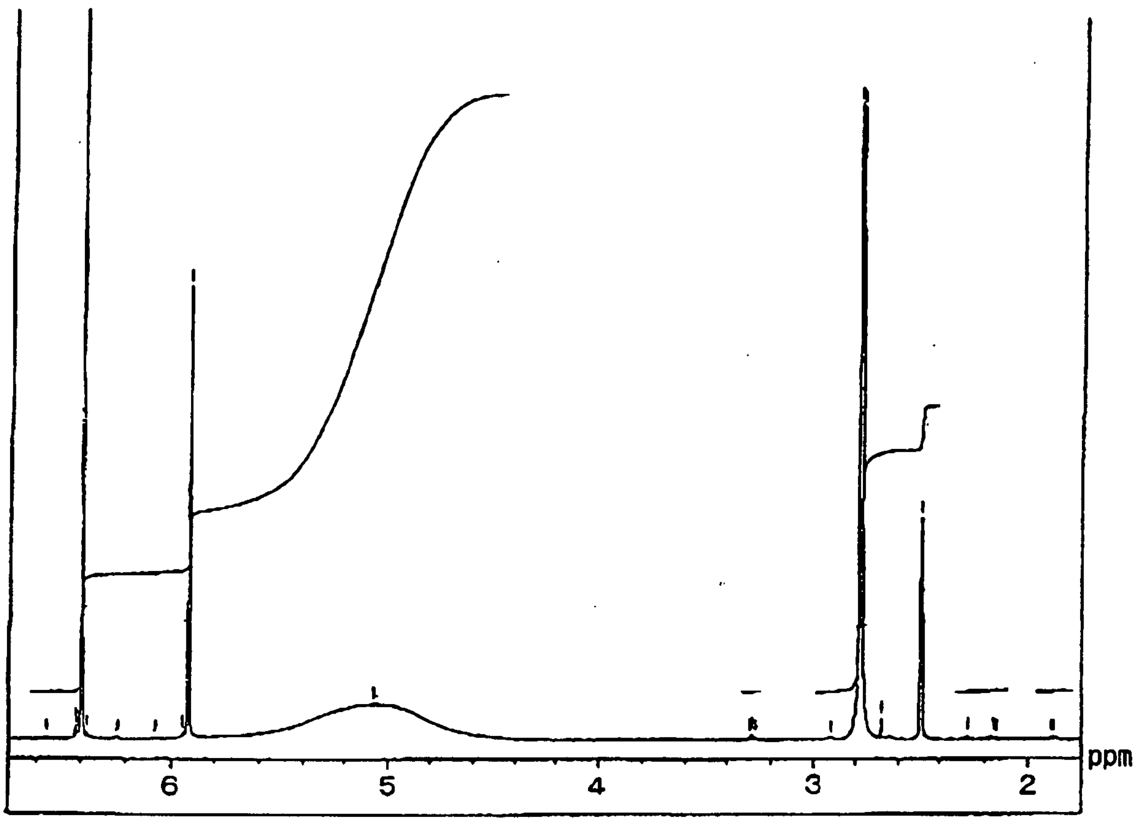


Fig. 5

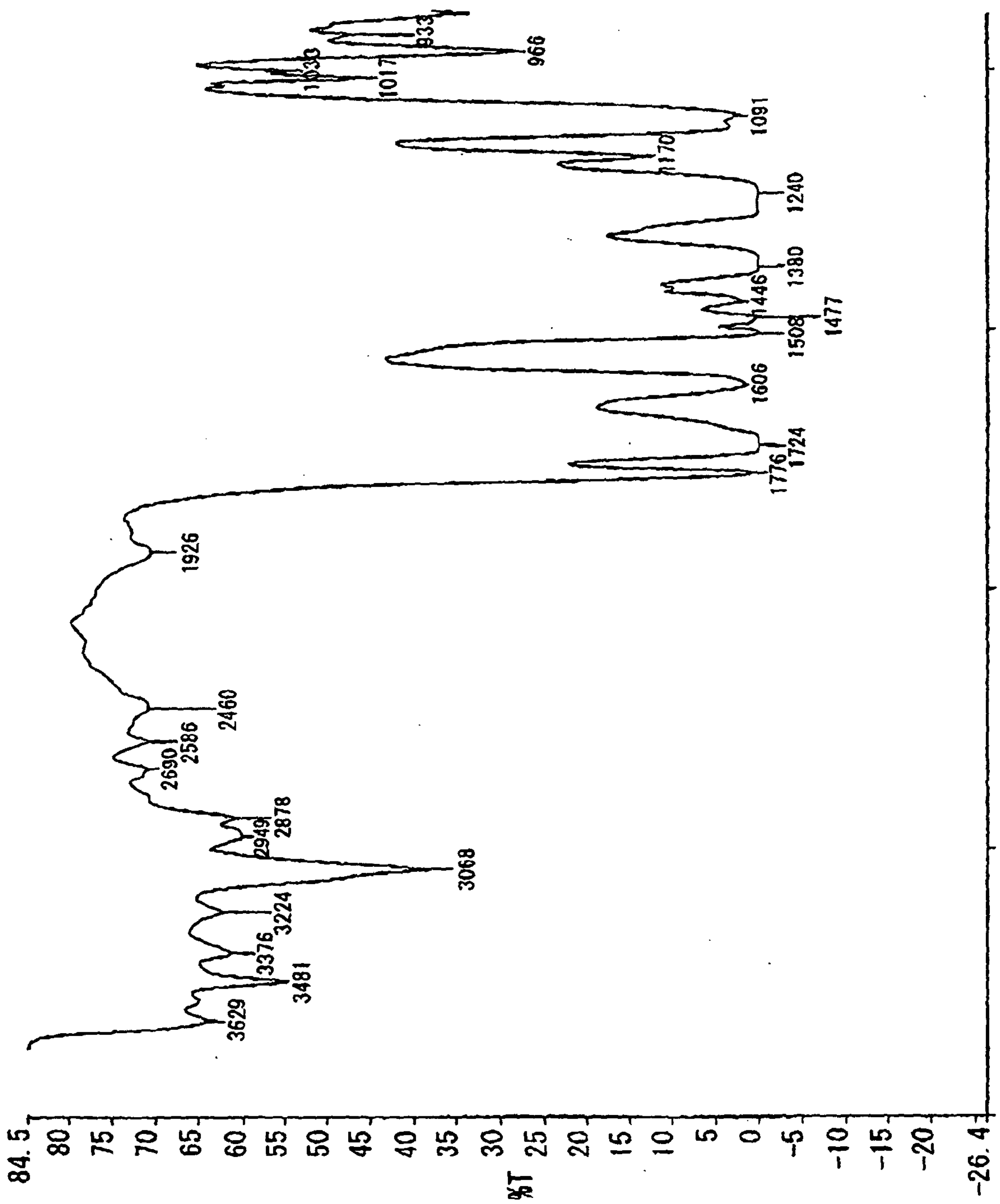
%T
cm-1
84.5
80
75
70
65
60
55
50
45
40
35
30
25
20
15
10
5
0
-5
-10
-15
-20
-26.4
4000.0
3000
2000
1500
1000
3629
3481
3376
3224
3068
2949
2878
2690
2586
2460
1926
1776
1724
1606
1508
1477
1446
1380
1240
1170
1091
1017
1033
966
933

Fig. 6

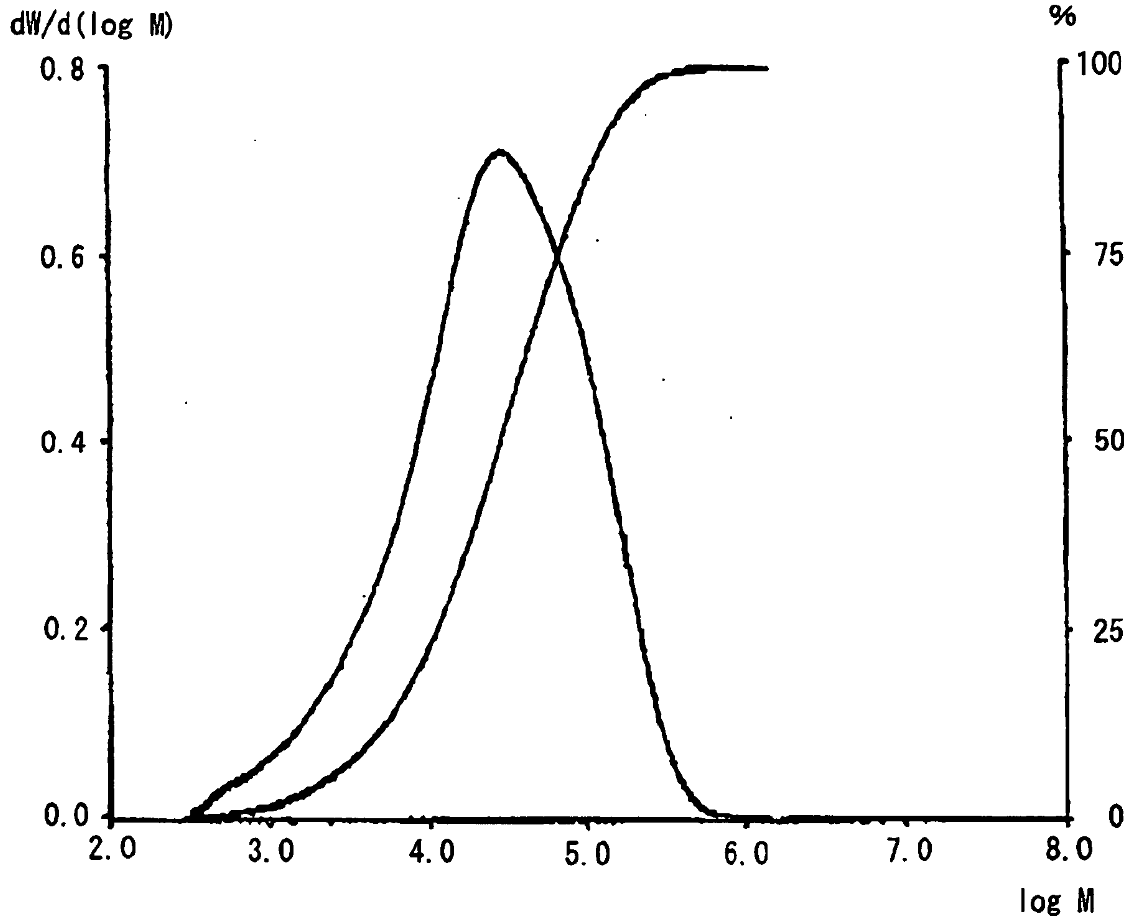


**Fig. 7**

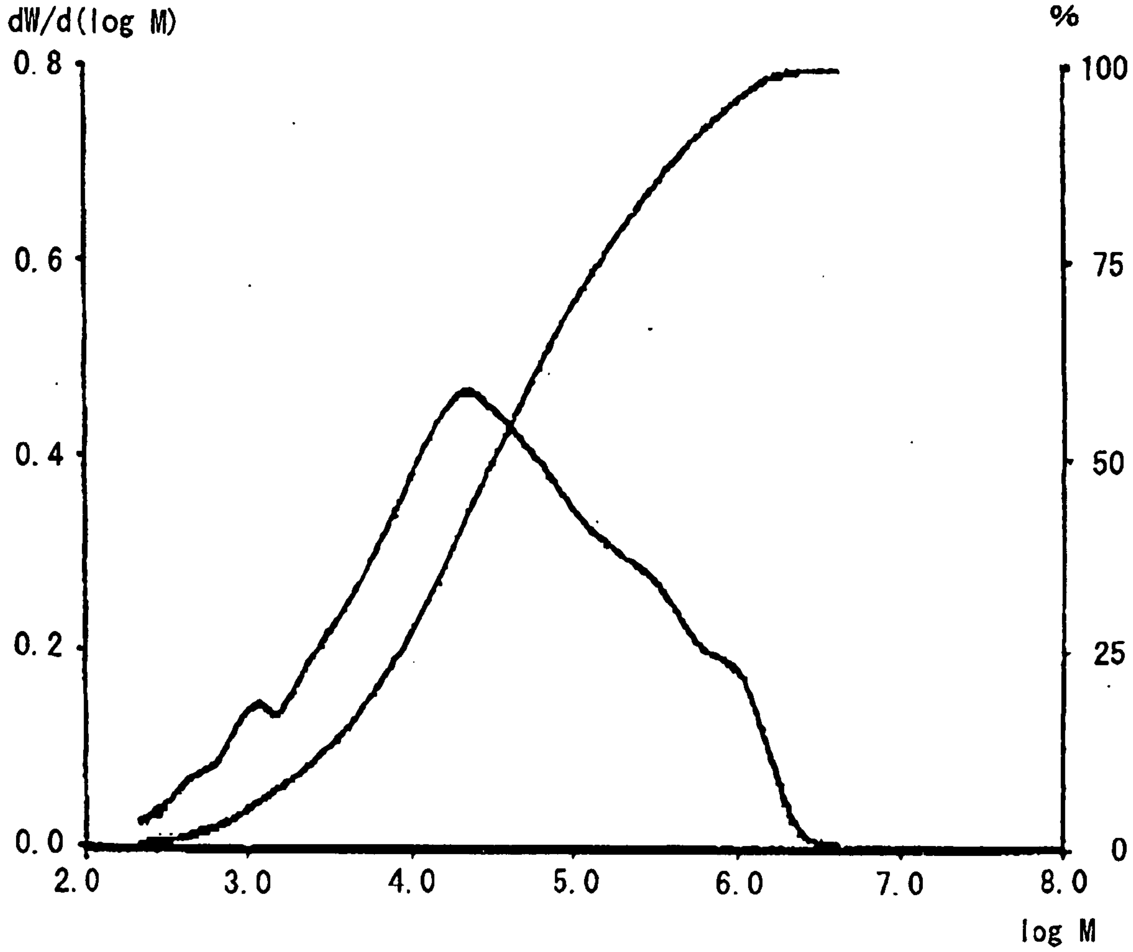


**Fig. 8**

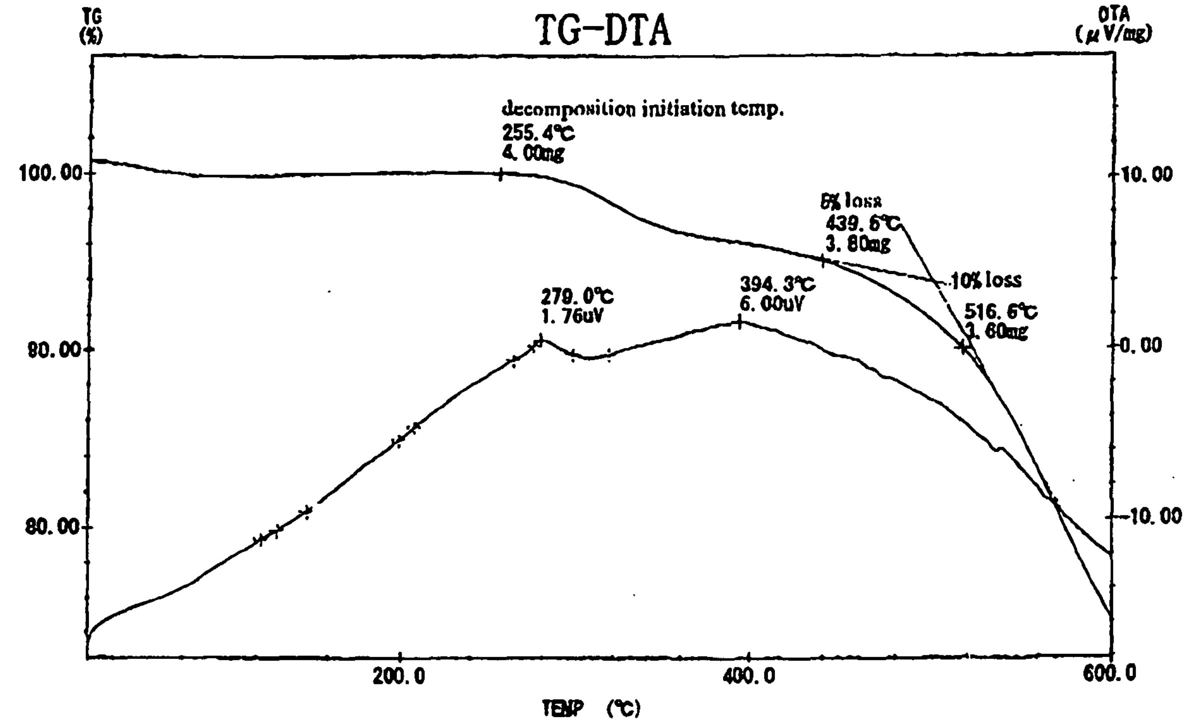
TG-DTA
TG (%)
DTA (μV/mg)
decomposition initiation temp.
255.4℃
4.00mg
5% loss
439.6℃
3.80mg
10% loss
516.6℃
3.60mg
279.0℃
1.76uV
394.3℃
6.00uV
100.00
90.00
80.00
10.00
0.00
-10.00
200.0
400.0
600.0
TEMP (℃)

**Fig. 9**

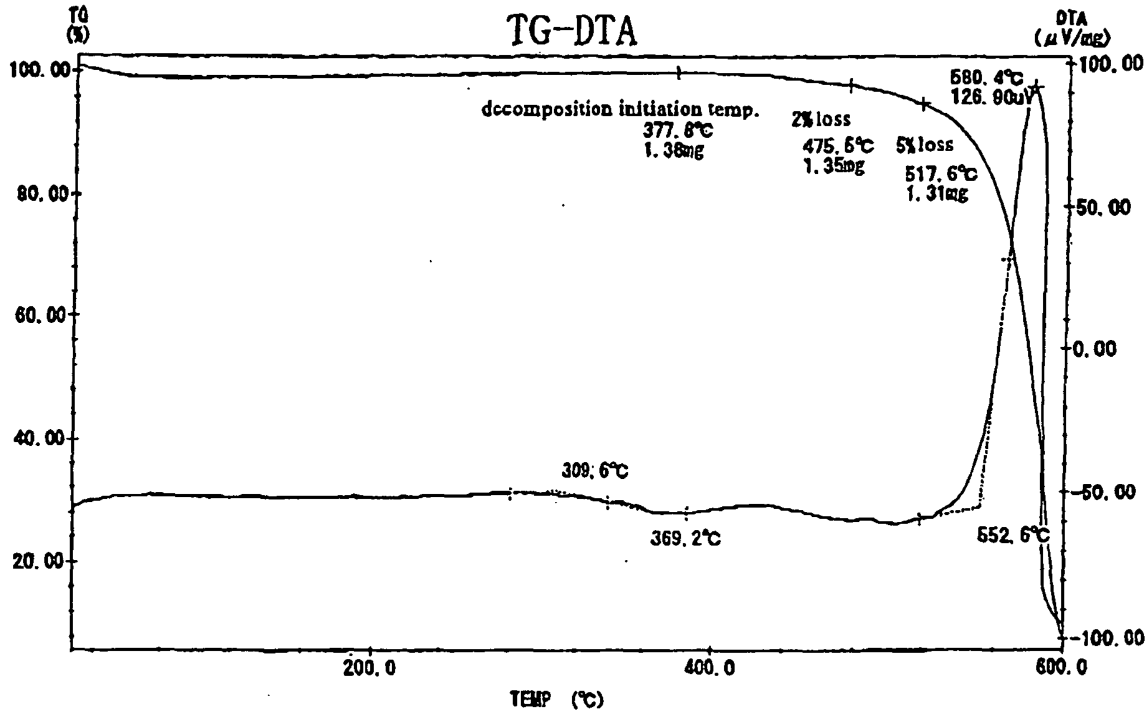
TG-DTA
TG (%)
DTA (μV/mg)
100.00
80.00
60.00
40.00
20.00
100.00
50.00
0.00
-50.00
-100.00
200.0
400.0
600.0
TEMP (℃)
decomposition initiation temp.
377.8℃
1.38mg
2% loss
475.5℃
1.35mg
5% loss
517.6℃
1.31mg
580.4℃
126.90uV
309.6℃
369.2℃
552.6℃

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5502143 A
- WO 9919771 A


### Non-patent literature cited in the description


- Science and Functions of Dendrimers. IPC, 2000
- *Macromolecules,* 2000, vol. 33, 1114
- *Macromolecules,* 2000, vol. 33, 6937
- *Macromolecules,* 2001, vol. 34, 3910
- *Macromolecules,* 2002, vol. 35, 5372
- *Macromolecules,* 2000, vol. 33, 4639
- *Macromolecules,* 2002, vol. 35, 3732